(19) Europäisches Patentamt

European Patent Office

Office européen des brevets

(11) **EP 1 475 963 B1**

(12) **EUROPEAN PATENT SPECIFICATION**

(45) Date of publication and mention
of the grant of the patent:
**20.09.2006 Bulletin 2006/38**

(51) Int Cl.:
***H04N 5/335*** *(2006.01)*

(21) Application number: **04252041.1**

(22) Date of filing: **06.04.2004**

(54) **Solid-state imaging device, signal processing device, camera and spectral device**

Festkörper-Bildaufnahme-Vorrichtung, Signalverarbeitungsvorrichtung, Kamera und Vorrichtung zur Aufnahme eines Spektrums

Dispositif d'imagerie à l'état solide, dispositif de traitement de signaux, caméra et capteur d'image spectrale

(84) Designated Contracting States:
**DE FR GB**

(30) Priority: **07.04.2003 JP 2003103359**
**04.06.2003 JP 2003159263**

(43) Date of publication of application:
**10.11.2004 Bulletin 2004/46**

(73) Proprietor: **MATSUSHITA ELECTRIC INDUSTRIAL CO., LTD.**
**Kadoma-shi, Osaka 571-8501 (JP)**

(72) Inventors:
• **Yamaguti, Takumi**
**cho**
**Ukyo-ku**
**Kyoto-shi**
**Kyoto 615-0081 (JP)**
• **Ueda, Daisuke**
**Ibaraki-shi**
**Osaka 567-0046 (JP)**
• **Katayama, Takuma**
**Nagaokakyou-shi**
**Kyoto 617-0833 (JP)**
• **Katsuno, Motonari**
**Yamashina-ku**
**Kyoto-shi**
**Kyoto 607-8411 (JP)**
• **Yoshida, Shinji**
**Takatsuki-shi**
**Osaka 569-0081 (JP)**

(74) Representative: **Crawford, Andrew Birkby et al**
**A.A. Thornton & Co.,**
**235 High Holborn**
**London WC1V 7LE (GB)**

(56) References cited:
EP-A- 0 619 614      EP-A- 0 809 303
US-A- 4 481 530      US-A- 5 914 749
US-A- 5 973 316      US-A- 6 057 586

**Description**

BACKGROUND OF THE INVENTION

(1) Field of the Invention

The present invention relates to solid-state imaging devices used in digital cameras and the like, and in particular to a technique for filters that cut light of unnecessary wavelength in a wavelength range to which photodiodes in a solid-state imaging device are sensitive, and for generating color signals from electric signals generated via the filters.

(2) Description of the Related Art

Conventional solid-state imaging devices perform color separation according to a color imaging method with either a single sensor device or with multi sensor devices. In the color imaging method with multi sensor devices, color signals are obtained by separating colors of an image with a color separation prism, and converting the separated image into an electric signal with use of three or four solid-state imaging devices. In contrast, in the color imaging method with a single sensor device, color signals are obtained by separating images with use of three or four color on-chip color filters formed in the one solid-state imaging device that converts the color separated image into electrical signals. The color imaging with a single sensor method uses either a primary color filter or a complimentary color filter, depending on the colors into which images are to be separated. For example, in the case of a primary color filter, an image is separated into three colors: red (R), green (G) and blue (B), and in the case of a complimentary color filter, an image is separated into four colors: cyan (Cy), magenta (Mg), yellow (Ye) and green (G) (for example, refer to Document 1).
Regardless of whether the method used uses a single sensor or multi sensors, a common feature is that an image is divided into two-dimensionally arranged pixels, and converted into electric signals.
For this reason, the following describes only a solid-state imaging device that uses a single sensor, and omits a description of the color imaging method with multi sensor devices.
Furthermore, since the method used up to converting the image to an electric signal is common to both methods, and the only difference is the colors obtained by separation, the color imaging method with a single sensor device is described as using the primary color filter rather than the complimentary color filter.

<Structure of a Conventional Solid-state imaging device>

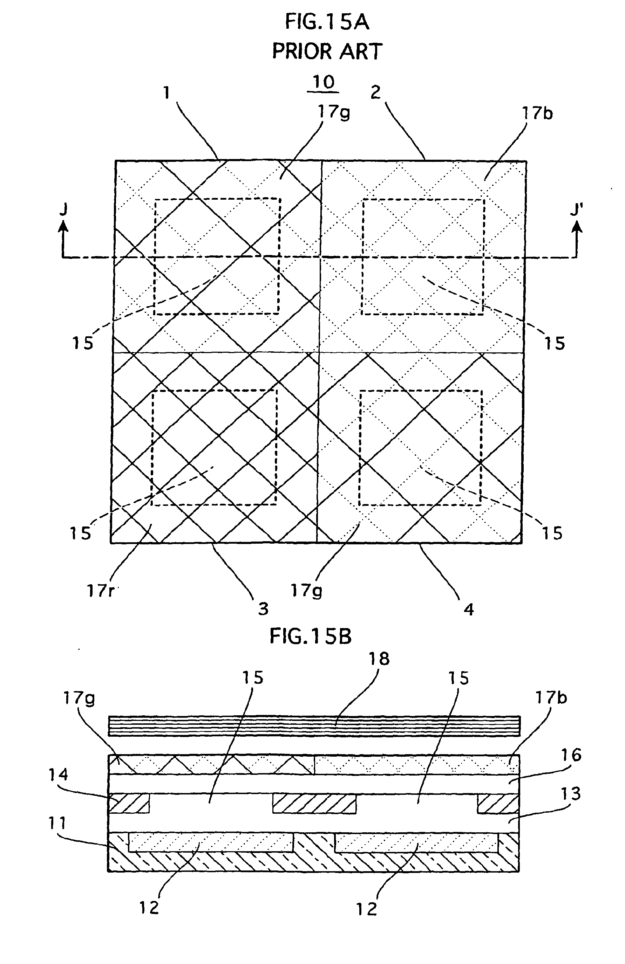

FIG. 15A is an upper surface view of a photoelectric conversion unit in a conventional solid-state imaging device, and FIG. 15B shows a cross section J-J' of the photoelectric conversion unit viewed toward an arrow direction.
Note that the pixels in the photoelectric conversion unit 10 are grouped in clusters called pixel units, and for brevity, only one of the pixel units (two by two pixels) is shown here.
As can be seen from FIGs . 15A and 15B, the photoelectric conversion unit 10 is composed of pixels arranged two-dimensionally. Each pixel unit corresponds to one pixel that is the smallest unit of an image.
The pixels 1 to 4 have a structure in which photodiodes 12 are formed in a semiconductor substrate 11, an insulating film 13, a light shield film 14, an insulating film 16 for planarizing, and the color filters 17r, 17b, and 17g (one per pixel) are formed in the stated order on the semiconductor substrate 11 in which the photodiodes 12 have been formed. The light shield film 14 is formed with apertures 15 therein. The photodiode 12, insulating film 13, and light shield film 14 are formed according to a wafer fabrication process, and the color filters 17r, 17b, and 17g is formed on the surface of the insulating film 16 according to an on-chip color filter manufacturing process.
This on-chip color filter manufacturing process consists of coating the surface of the insulating film with a resin film, exposing and the resin film using a hot mask, and then developing the resin film, thereby forming a dye pattern. The color filter is then formed in the pattern with pigment, dye, or the like.
A color is assigned to each pixel according to the Bayer pattern, and a color filter of the assigned color is formed for each pixel. Here, each of three pixels making up one group has a different one of the colors. As one example, as shown in the drawings, pixels 1 and 4 each have a green color filter 17g, pixel 2 has a blue color filter 17b, and pixel 3 has a red color filter 17r.
Furthermore, an infrared ray cut filter 18 is provided above the color filters 17r, 17g and 17b of the pixels 1 to 4.
Light incident on the photoelectric conversion unit 10 passes through the infrared ray cut filter 18, then the color filter 17r, 17g, or 17b, and passes through the aperture 15 to be photoelectric converted to electrons by the photodiode 12.

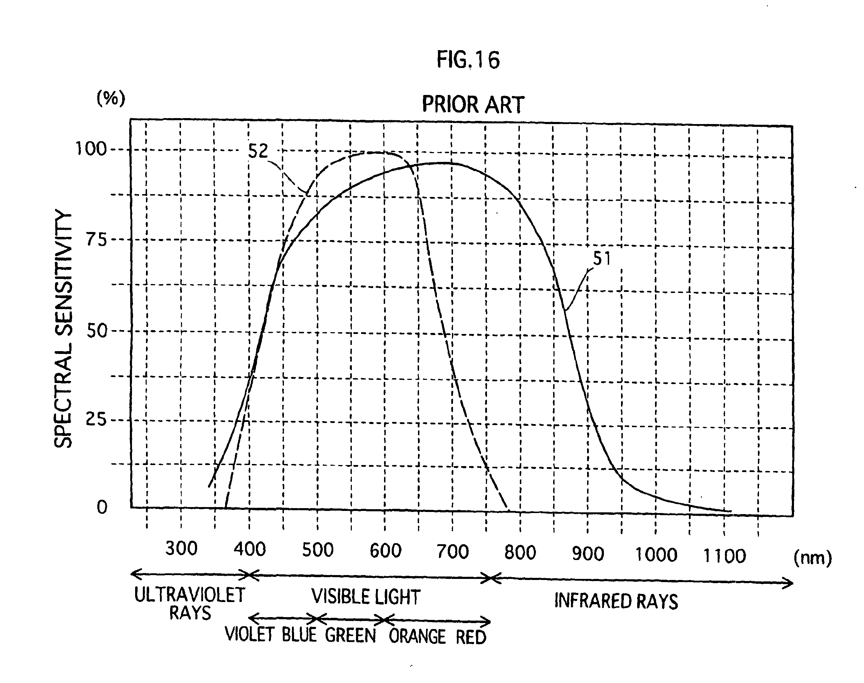

FIG. 16 is a graph showing spectral sensitivity characteristics of a photodiode and sensitivity characteristics of the human eye.
In this drawing, a curve 51 shows spectral sensitivity of a photodiode that uses silicon PN junction, while a curve 52 shows sensitivity characteristics of the human eye.

As shown by the curve 51, of wavelengths ranging from visible light through to infrared rays, a photodiode that uses silicon PN junction is particularly sensitive to light in a range 300 nm to 1100 nm, with sensitivity peaking at 600 nm to 750 nm.

Here, visible light is a type of electromagnetic wave in a range of 380 nm to 780 nm, and colors such as violet, blue, green, orange and red (in order of shortness of wavelength) are perceptible by the human eye. Infrared rays are a type of electromagnetic wave whose wavelength is longer than visible light, and are divided, in order of closeness to visible light, into near infrared light (0.78 μ to 3 μ), mid-infrared light (3 μ to 30 μ), and far infrared light (30 μ to 1 mm).

As can be seen from the curve 52, in contrast to the photodiode, visual sensitivity indicated by the sensitivity characteristics of the human eye peaks with light of a wavelength of 555 nm (green light), and decreases as the wavelength becomes both shorter (towards the blue side) and longer (towards the red side).

The curves 51 and 52 demonstrate that it is necessary to eliminate the effect of infrared rays beyond the visible range on the photodiodes 12 as much as possible in solid-state imaging devices for digital cameras. This is because it is important to be able to measure the amount of light in a range visible to humans.

The infrared filter 18 is provided in the photoelectric conversion unit 10 for this reason.

A certain level of performance in photoelectric conversion is achieved in the photoelectric conversion unit 10 by providing color filters 17r, 17g and 17b above the photodiodes 12 in order to obtain color signals, coupled with the infrared ray cut filter 18 further provided above the color filters 17r, 17g and 17b.

However, in addition to the wafer fabrication process, an on-chip color filter manufacturing process is necessary for forming the color filters and the infrared ray cut filter when manufacturing the solid-state imaging device. In other words, the necessity of performing a plurality of manufacturing processes gives rise to a problem that solid-state imaging devices are time consuming and costly to manufacture.

In addition, it is necessary to manufacture color filters and infrared ray cut filters having precise spectral characteristics if a photoelectric conversion unit having performance above a certain level is to be manufactured. This also causes problems of reduced yield and high manufacturing costs.

Document 1: ANDO, Takao and KOMOBUCHI, Hiroyoshi, *Kotai Satuzo Soshi no* Kiso, Denshi no Me no Shikumi (The Fundamentals of Solid-State Imaging Devices: *The Structure of Electronic Eyes),* Nihon Riko Shuppankai, December 5, 1999, pp. 183-188

US-A-5 914 749 discloses a colour imaging device of a plurality of light selective elements. The light selective elements include a first light selective element selective to light having a wavelength corresponding to the Magenta region of the spectrum, a second light selective element selective to light having a wavelength corresponding to the White region of the spectrum, and a third light selective element selective to light having a wavelength corresponding to the Yellow region of the spectrum.

US-A-5 973 316 discloses a sub-wavelength aperture array suitable for filtering light of a predetermined wavelength traversing the apertures, comprising a metallic film having apertures located therein and arranged with a selected size and spacing in a pattern so that when light is incident on the apertures, surface plasmons on the metallic film are perturbed resulting in an enhanced transmission of the light emitted from individual apertures in the array.

EP-A-0 619 614 discloses a photodiode image sensor including a lens array with individual lenses, each lens positioned over a specific photodiode. There is a light shield for each photodiode, which has a lengthened aperture with two incident light regions. Each lens is arranged over a lens region of the aperture to focus light from an object on one section of the photodiode and also so that object light directly illuminates a second section of the photodiode through a non-lens region of the aperture. A colour filter array may be positioned between the lens array and the light shield.

US-A-6 057 586 discloses the use of a light shield to modulate pixel colour responsivity. The improved pixel includes a substrate having a photodiode with a light receiving area, with a colour filter array material of a first colour disposed above the substrate. The pixel has a first relative responsivity. A light shield is disposed above the substrate to modulate the pixel colour responsivity. The light shield forms an aperture whose area is substantially equal to the light receiving area adjusted by a reduction factor, which is the result of an arithmetic operation between the first relative responsivity and a second relative responsivity, associated with a second pixel of a second colour.

SUMMARY OF THE INVENTION

In view of the described problems, the object of the present invention is to provide a solid-state imaging device, and a camera in which the solid-state imaging device is used, that enable reduced manufacturing time and cost, and improve yield, while also achieving high picture quality equivalent to or greater than a conventional solid-state imaging device.

In order to solve the state problem, the present invention is a solid-state imaging device, as defined in claim 1.

According to the stated structure, in the solid-state imaging device of the present invention, the apertures provided in the light shield film function as high pass filters, and enable light of the predetermined wavelength or greater to be cut off. Specifically, an infrared ray cut filter and color cut filters can be omitted from the solid-state imaging device because the apertures in the light shield film cut off light having a wavelength longer than a certain wavelength. Furthermore, the precision with which the infrared ray cut filter blocks infrared light and the spectral characteristics of the color filters can be eased considerably.

For example, if the predetermined wavelength is a wavelength at the edge of visible light, and apertures that cut off a wavelength at the edge of visible light are provided in the light shield film, the precision with which the infrared filter cuts off infrared light can be eased considerably.

This is because even if infrared rays were to pass through the infrared ray cut filter, these infrared rays would be cut off by the apertures and therefore not reach the photodiodes.

Similarly, the precision of the spectral characteristics of the color filters in regard to wavelengths longer than visible light that is intended to pass through the color filters can be eased considerably.

In other words, the infrared filter can be omitted, or be provided but with considerably reduced precision in cutting off infrared light, and the color filters can be omitted, or be provided but with considerably reduced precision of the spectral characteristics in regard to wavelengths longer than visible light that is intended to pass through the color filters. As a result, the solid-state imaging device manufacturing process can be simplified, and yield of infrared ray cut filters and color filters can be improved considerably.

Consequently, the stated structure enables reduced solid-state imaging device manufacturing time, reduced cost, and improved yield.

Furthermore, material characteristics of the infrared filter and the color filters can be eased, and the materials used for the infrared filter and the color filters can be selected from an expanded range of materials.

Furthermore, the photodiodes may correspond respectively to pixels that are each a minimum unit of an image that is taken, and each of the photodiodes may have a different one of the apertures provided thereabove.

According to the stated structure, the frequency of light received can be limited for each pixel. Therefore, the color filter can be omitted from each pixel, or the spectral characteristic of the infrared filter and the color filters can be eased considerably.

Furthermore, since a shape and a dimension of each aperture are defined according to the predetermined wavelength, the wavelength cut off by the apertures can be changed by changing the shape and dimensions of the apertures.

Furthermore, the apertures may be made up of $N$ ($N$ being a natural number) different types of the apertures, the predetermined wavelength may be different for each type of aperture, the photodiodes are $N$ in number, and each of the $N$ photodiodes may have an aperture of a different one of the $N$ types provided thereabove.

According to the stated structure, electric charge that is generated according to differing wavelengths can be gathered in each photodiode. Therefore, an electric signal can be obtained that is equivalent to an electric signal of light of a frequency that passes through a color filter of high precision.

Furthermore, the solid-state imaging device may generate color signals of a first color system from $N$ ($N$ being a natural number) types of electric signals generated from light received by the photodiodes which are $N$ in number, based on an $M$ ($M$ being a natural number) by $N$ matrix for converting a column vector whose compositional elements are N types of electric signals, into a column vector whose compositional elements are $M$ types of color signals of the first color system.

According to the stated structure, color signals can be generated from electric signals generated by simply gathering electric charge born from light in a specific wavelength range, rather than from electric signals such as the three primary color signals of red, green and blue that are generated from light obtained using color filters. Therefore, colors can be realized without relying on color filters.

Furthermore, the solid-state imaging device may apply colour correction to the color signals of the first color system, based on an $M$ by $M$ matrix for correcting the column vector whose compositional elements are the color signals of the first color system.

According to the stated structure, even if the generated color signal deviates from the desired color, the desired color can be reproduced by correcting the color signal.

Furthermore, the solid-state imaging device may convert the color signals of the first color system into color signals of a second color system, based on an $L$ ($L$ being a natural number) by $M$ matrix for converting the column vector whose compositional elements are color signals of the first color system into a column vector whose compositional elements are color signals of the second color system.

According to the stated structure, even if generated color signals are of a color system that is different to the desired color system of color signal, color signals of the desired color system can be generated based on the color signal of the different color system, and therefore the desired color system can be reproduced.

Furthermore, the solid-state imaging device may apply color correction to the color signals of the second color system, the color correction being based on an $L$ by $L$ matrix for correcting a column vector whose compositional elements are color signals of the second color system.

According to the stated structure, even if the converted color signal deviates from the desired color, the desired color can be reproduced by correcting the converted color signal.

Furthermore, each photodiode may have a plurality of the apertures are provided thereabove.

According to the stated structure, the amount of light able to be received by each photodiode below each plurality of apertures can be increased. Therefore, the sensitivity of the photodiodes can be increased considerably, and high picture quality can be achieved.

Furthermore, the plurality of apertures provided above each photodiode may consist of (i) one or more apertures that enable light below the predetermined wavelength to pass through, and (ii) one or more apertures that enable light below a different predetermined wavelength to pass through.

According to the stated structure, a plurality of apertures enable light below the predetermined wavelength to pass, and the spectral characteristics of light in a vicinity of a maximum wavelength of light that one photodiode is able to receive can be finely adjusted.

Consequently, the spectral characteristics in the vicinity of the maximum wavelength that each photodiode receives are able to be adjusted with a plurality of types of maximum wavelengths, and the photodiodes are able to receive light of the desired wavelength.

Furthermore, the apertures may be arranged so that lengthwise directions of the aperture are parallel with each other, an interval between each aperture being less than or equal to a length direction dimension of the apertures.

According to the stated structure, the number of apertures in each pixel is increased. Therefore, the area occupied by apertures increases and sensitivity also increases.

Furthermore, the apertures may arranged so that lengthwise directions of the aperture are parallel with each other, an interval between each aperture being greater than or equal to a length direction dimension of the apertures.

According to the stated structure, light of a wavelength that is longer than light allowed to pass through the apertures can be prevented from passing through.

Furthermore, the solid-state imaging device may further include: a plurality of microlenses, each of which is provided with respect to a different one of the photodiodes and covers the aperture above the respective photodiode.

According to the stated structure, not only light in the apertures, but also light above the light shield film is focused in the apertures. Therefore, a greater amount of light can be received by the photodiodes, and high-sensitivity can be achieved. Furthermore, by adjusting the size of the microlenses, the amount of light that is received by each photodiode can be adjusted according to the performance required from the diode.

Furthermore, the solid-state imaging device may further include: a plurality of microlenses, each of which covers a different one or more of the apertures.

According to the stated structure, the light-collecting rate of the apertures can be improved considerably, and high-sensitivity can be achieved. Furthermore, the amount of light can be adjusted individually for each aperture, and individually for each wavelength.

Furthermore, the insulating film may be of a thickness that is equal to or greater than a minimum dimension of the apertures, and equal to or less than a maximum wavelength of light to be converted by the photodiodes.

According to the stated structure, the effect of light of a wavelength that attenuates before reaching the photodiodes (in particular, light close to the maximum wavelength) can be reduced, even in the light that passes through the apertures. This achieves high picture quality with little mixing of colors.

Furthermore, each aperture may be one of rectangular and circular in shape, and the dimension defined according to the predetermined wavelength may be a long side of the aperture if the aperture is rectangular, and a diameter of the aperture if the aperture is circular.

According to the stated structure, the dimensions of the apertures can be easily specified.

Furthermore, the predetermined wavelength may be a wavelength of one of near infrared light, red light, green light, and blue light in a medium formed over the aperture.

According to the stated structure, three or more types of spectral signals having respectively different predetermined wavelengths can be achieved, and the three primary colors can be realized. Therefore, colors can be realized without relying on an infrared filter and color filters.

Furthermore, the apertures may have a long, narrow rectangular shape, and be arranged such that a lengthwise direction of each aperture is oriented in a same direction.

According to the stated structure, a polarized component of light having an electric field in the lengthwise direction can be gathered in the photodiodes. Therefore, false signals caused by diffused reflection are prevented. Furthermore, only light of a predetermined polarized component is able to be received by the photodiodes, and prevention of mixing of color signals, and polarization accuracy are improved. As a result, high picture quality can be achieved.

Furthermore, the apertures may have a long, narrow rectangular shape, a plurality of apertures is provided with respect to each photodiode, and be arranged such that a lengthwise direction of the apertures for each photodiode is oriented in one of (i) a first direction and (ii) a second direction that is orthogonal to the first direction.

According to the stated structure, the polarized component of light can be separated according to pixel. Therefore, false signals caused by diffused reflection can be prevented, and the photodiodes receive only the desired polarized light. As a result, mixing of color signals is prevented, polarization accuracy is heightened, and high picture quality can be achieved.

Furthermore, the present invention is a camera that includes a solid-state imaging device according to claim 2.

According to the stated structure, the infrared filter can be omitted, or be provided but with considerably reduced precision in blocking infrared light, and the color filters can be omitted, or be provided but with considerably reduced precision of the spectral characteristics. As a result, the solid-state imaging device manufacturing process can be simplified, and yield of infrared ray cut filters and color filters can be improved considerably.

Consequently, the stated structure enables reduced solid-state imaging device manufacturing time, reduced cost, and improved yield.

As a result, a low-priced, high-performance camera can be provided.

Furthermore, the apertures may be made up of N (N being a natural number) different types of the apertures, the predetermined wavelength may be different for each type of aperture, the photodiodes are N in number, and each of the N photodiodes may have an aperture of a different one of the N types provided thereabove, and the solid-state imaging device may further include: a signal processing circuit that processes N types of electric signals generated from light received respectively by the N photodiodes provided above the apertures whose form and dimensions are def ined based on the respective predetermined wavelength, and the signal processing device may generate, from the N types of electric signals, color signals of a first color system, based on a differential matrix for converting a vector whose compositional elements are the N types of electric signals into a vector whose compositional elements are M (M being a natural number) types of color signals of a first color system, by taking a difference between an electric signal in the N types of electric signals and a neighboring electric signal in the N types of electric signals.

According to the stated structure, the wavelength cut off by the apertures can be changed if the shape and dimensions of the apertures are changed. This enables electric charge of different wavelength ranges to be gathered. For example, the combination of color filters and apertures enables light to be restricted for each color of color filter, even if the precision of spectral characteristics of the color filters is eased. Furthermore, color signals can be generated from electric signals generated by simply gathering electric charge of differing wavelengths, rather than from electric signals such as three primary color signals of red, green and blue. Therefore, colors can be realized without relying on color filters.

Furthermore, the camera may further include a signal processing apparatus that processes N (N being a natural number) types of electric signals output by the solid-state imaging device, wherein, in the solid-state imaging device, the apertures are made up of N different types of the apertures, the predetermined wavelength is different for each type of aperture, the photodiodes are N in number, and each of the N photodiodes has apertures of a different one of the N types provided thereabove, the solid-state imaging device outputs to the signal processing device, N types of electric signals generated from light received respectively by the N photodiodes provided above the apertures whose shape and dimensions are defined based on the respective predetermined wavelength, and the signal processing device generates, from the N types of electric signals, color signals of a first color system, based on a differential matrix for converting a vector whose compositional elements are the N types of electric signals into a vector whose compositional elements are M (M being a natural number) types of color signals of a first color system, by taking a difference between an electric signal in the N types of electric signals and a neighboring electric signal in the N types of electric signals.

According to the stated structure, the described effects can be obtained in a camera with a single sensor device in which the solid-state imaging device and the signal processing devices are incorporated.

Furthermore, the camera may further include: at least one more of the solid-state imaging device, the solid-state imaging devices totaling N in number, and in each solid-state imaging device, the apertures being made up of N (N being a natural number) different types of the apertures, the predetermined wavelength being different for each type of aperture, the photodiodes which being N in number, and each of the N photodiodes having apertures of a different one of the N types provided thereabove; and a signal processing device that processes N types of electric signals output by the solid-state imaging device, wherein the solid-state imaging device outputs to the signal processing device, N types of electric signals generated from light received respectively by the N photodiodes provided above the apertures whose shape and dimensions are defined based on the respective predetermined wavelength, and the signal processing device generates, from the N types of electric signals, color signals of a first color system, based on a differential matrix for converting a vector whose compositional elements are the N types of electric signals into a vector whose compositional elements are M (M being a natural number) types of color signals of a first color system, by taking a difference between an electric signal in the N types of electric signals and a neighboring electric signal in the N types of electric signals.

According to the stated structure, the described effects can be obtained in a camera with multi sensor devices in which a plurality of the solid-state imaging devices and the signal processing devices are incorporated.

BRIEF DESCRIPTION OF THE DRAWINGS

These and other objects, advantages and features of the invention will become apparent from the following description thereof taken in conjunction with the accompanying drawings which illustrate a specific embodiment of the invention.

In the drawings:

FIG. 1 is a perspective drawing schematically showing a digital camera and a solid-state imaging device used therein;

FIG. 2A is an upper surface view of a photoelectric conversion unit in a solid-state imaging device of the first embodiment, and FIG. 2B shows a cross section A-A' of the photoelectric conversion unit viewed toward an arrow direction;

FIG. 3 shows a list of refractive indexes of principal materials of the solid-state imaging device;

FIG. 4 is a graph showing spectral characteristics of the solid-state imaging device of the first embodiment;

FIG. 5A is an upper surface view of a photoelectric conversion unit in a solid-state imaging device of the second embodiment, and FIG. 5B shows a cross section B-B' of the photoelectric conversion unit viewed toward an arrow direction;

FIG. 6 is a graph showing spectral characteristics of the solid-state imaging device of the second embodiment;

FIG. 7A is an upper surface view of a photoelectric conversion unit in a solid-state imaging device of the third embodiment, and FIG. 7B shows a cross section C-C' of the photoelectric conversion unit viewed toward an arrow direction;

FIG. 8A is an upper surface view of a photoelectric conversion unit in a solid-state imaging device of the fourth embodiment, and FIG. 8B shows a cross section D-D' of the photoelectric conversion unit viewed toward an arrow direction;

FIG. 9 is a graph showing spectral characteristics of the solid-state imaging device of the fourth embodiment;

FIG. 10A is an upper surface view of a photoelectric conversion unit in a solid-state imaging device of the fifth embodiment, and FIG. 10B shows a cross section E-E' of the photoelectric conversion unit viewed toward an arrow direction;

FIG. 11 is a functional block diagram showing the structure of the solid-state imaging device of the sixth embodiment;

FIG. 12A is an upper surface view of a photoelectric conversion unit in a solid-state imaging device of the sixth embodiment, and FIG. 12B shows a cross section F-F' of the photoelectric conversion unit viewed toward an arrow direction;

FIG. 13 is a graph showing spectral characteristics that deviate considerably from the ideal spectral characteristics;

FIG. 14A is an upper surface view of a photoelectric conversion unit in a solid-state imaging device of the seventh embodiment, and FIG. 14B shows a cross section G-G' of the photoelectric conversion unit viewed toward an arrow direction;

FIG. 15A is an upper surface view of a photoelectric conversion unit in a conventional solid-state imaging device, and FIG. 15B shows a cross section J-J' of the photoelectric conversion unit viewed toward an arrow direction;

FIG. 16 is a graph showing spectral sensitivity characteristics of a photodiode and sensitivity characteristics of the human eye;

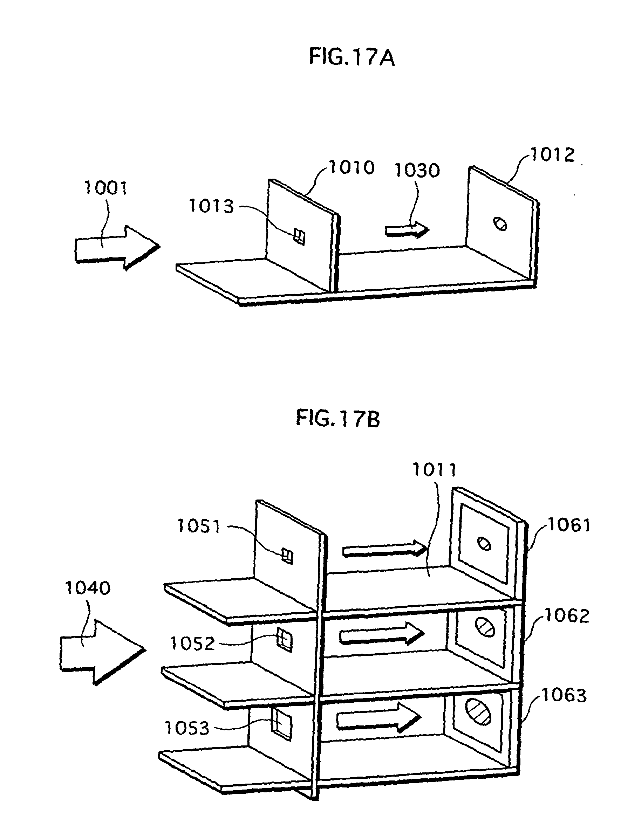

FIG . 17A shows an example of the structure of a spectral device that spectrally separates one type of light, and FIG. 17B shows an example of a spectral device that spectrally separates into a plurality of types of light; and

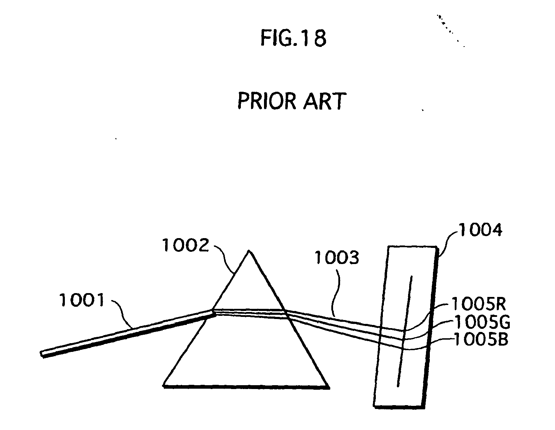

FIG. 18 shows an example of the structure of a spectral device that uses a prism.

DESCRIPTION OF THE PREFERRED EMBODIMENT

<First Embodiment>

The following describes a first embodiment of the present invention with reference to the drawings. Note that structural elements having the same structure as those in the Description of the Related Art have the same numbering thereas, and are omitted from the following description. Furthermore, the embodiments are based on a premise that, roughly speaking, infrared rays (IR) are light of 780 nm to 3 $\mu$m, red light (R) is light in the vicinity of 610 nm, green light (G) is light in the vicinity of 540 nm, and blue light (B) is light in the vicinity of 450 nm.

<Outline of the First Embodiment>

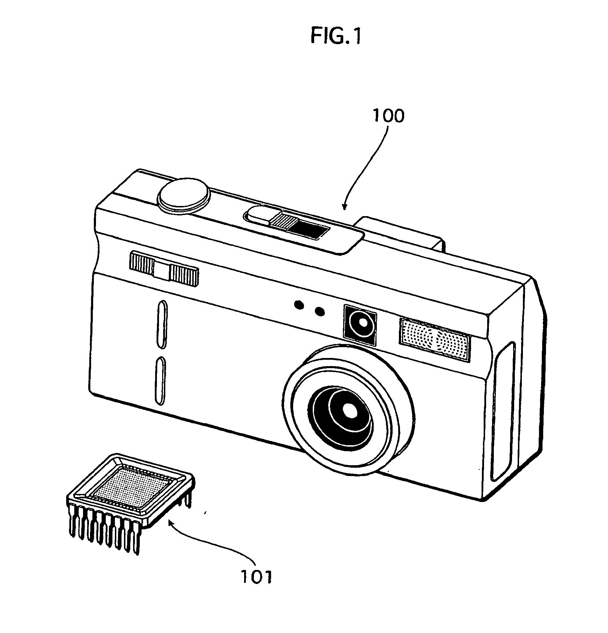

FIG. 1 is a perspective drawing schematically showing a digital camera and a solid-state imaging device used therein.

As can be seen from FIG. 1, a solid-state imaging device 101 used in a digital camera 100 is the same as the conventional solid-state imaging device in that light incident on the solid-state imaging device (hereinafter called "incident light") via sealing glass that protects a photoreceptive surface is photoelectric converted to electrons by a photoelectric conversion unit (the area indicated by dots in the drawing).

The solid-state imaging device 101 differs from the conventional device in that instead of being provided with the infrared ray cut filter 18, infrared light is cut off by the apertures 15 having a reduced size. This structure is based on a concept of having the apertures 15 function as high pass filters in the manner of a waveguide that cuts off electromagnetic waves exceeding a wavelength corresponding to the dimensions of the long side of the aperture 15 (hereinafter, also called "long side dimension").

<Waveguide>

The following describes a waveguide that is representative of microwave transmission lines. Note that microwaves and light are both electromagnetic waves that satisfy Maxwell's equation.

A waveguide is a pipe whose walls are made of a highly conductive material such as copper. Waveguides are classified as rectangular, elliptical and so on, according to their cross-sectional shape. Note that it is commonly known that waveguides have a cutoff frequency determined by the structural dimensions of the cross section, and are unable to transmit signals below the cutoff frequency.

Taking for example a rectangular waveguide having a width $a$ and a height $b$, the cutoff frequency $f_c$ of the waveguide is shown by the following Equation (1). Furthermore, the wavelength $\lambda_c$ corresponding to the cutoff frequency (hereinafter called "cutoff wavelength") is shown by the following Equation (2). Here, the height b is assumed to be greater than the width $a$. In an elliptical waveguide having a radius $r$, the cutoff frequency $f_c$ is shown by the following Equation (3), and the cutoff wavelength $\lambda_c$ is shown by the following Equation (4). Note that it is assumed that the waveguide is filled with an isotropic, homogenous medium having a permittivity $\varepsilon$ and a permeability $\mu$. A velocity $v$ of plane waves in the medium is shown by the following Equation (5).

$$(1) \quad f_c \ = \ \frac{v}{2a}$$

$$(2) \quad \lambda_c \ = \ 2a$$

$$(3) \quad f_c \ = \ \frac{v}{3.413r}$$

$$(4) \quad \lambda_c \ = \ 3.413r$$

$$(5) \quad v \ = \ \frac{1}{\sqrt{\varepsilon\mu}}$$

The following describes the solid-state imaging device of the first embodiment in view of the stated features.

<Structure of the Solid-state imaging device of the First Embodiment>

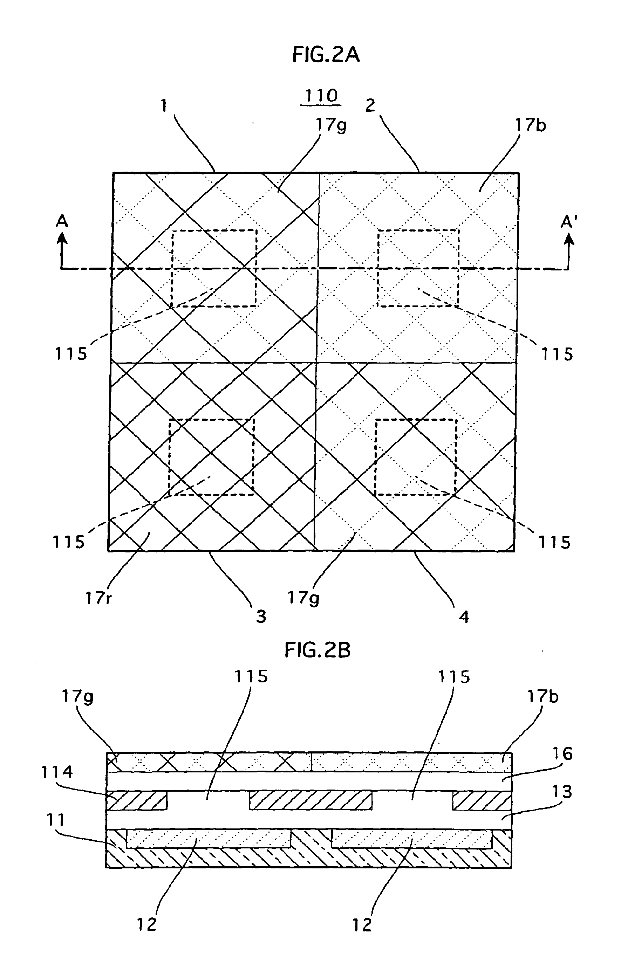

FIG. 2A shows the photoelectric conversion unit of the solid-state imaging device of the first embodiment as viewed from above, and FIG. 2B shows a cross section A-A' of the photoelectric conversion unit viewed toward an arrow direction.

Note that for brevity, only one of the pixel units (two by two pixels) among the pixel units that make up the photoelectric conversion unit 110 is shown.

As can be seen from FIGs . 2A and 2B, the light shield film 114 in the photoelectric conversion unit 110 is formed with apertures 115 therein. Each aperture 115 is located below a color filter 17r, 17g or 17b, with the insulating film 16 therebetween. The infrared ray cut filter 18 that is provided above the color filters 17r, 17g, and 17b in the conventional photoelectric conversion unit 10 is omitted in the photoelectric conversion unit 110.

Each photodiode 12, on receiving light, generates electrons and positive holes according to light received in a vicinity of a PN junction boundary, and efficiently converts the received light into current, based on the generated electrons and positive holes. The sensitivity of the photodiodes varies according the wavelength of the light, and the shorter the wavelength, the shallower from the surface the position where light is effectively absorbed. Note that electrons and positive holes generated in a position removed from the PN junction do not contribute to current generation because they re-bond and dissipate before reaching the depletion layer.

For this reason, when making a photodiode that is sensitive to long wavelengths, it is necessary to form a deep PN junction, and when making a photodiode that is sensitive to short wavelengths, it is necessary to form a PN junction close to the silicon surface.

As one example, in the following the photodiodes 12 are assumed to be photodiodes sensitive to light of a wavelength of 270 nm to 1000 nm, with sensitivity peaking at 700 nm to 800 nm. Furthermore, the insulating films 13 and 16 are made of silicon oxide ($SiO_2$) or silicon nitride ($Si_3N_4$), and the light shield film 114 is made of aluminium (Al) or tungsten silicide (W-Si).

<Dimensions of the Apertures>

The apertures 115 have smaller dimensions that the apertures 15, and cut off light of a wavelength exceeding the cutoff wavelength $\lambda_c$ defined by the dimensions and shape of each aperture 115. When light of a wavelength $\lambda_i$ is incident to the aperture 115 via the insulating film 16 having a refractive index $N_r$, the wavelength $\lambda_r$ of the light in the insulating film 16, taking into account the refractive index of the insulating film 16, is shown by the following Equation (6).

$$(6) \quad \lambda_r = \frac{\lambda_i}{N_r}$$

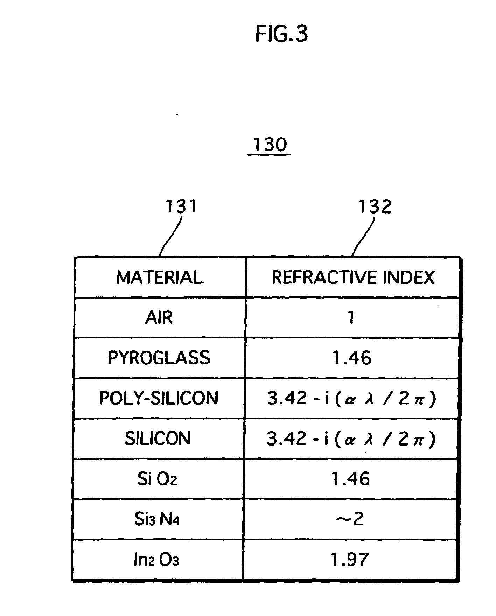

FIG. 3 shows a list of refractive indexes of principal materials of the solid-state imaging device.

As can be seen from FIG. 3, a list 130 shows materials in column 131 and the respective refractive indexes of the materials in column 132.

If, for example, the insulating film 16 is silicon oxide ($SiO_2$) and light incident on the insulating film 16 has a wavelength of 780 nm (infrared rays), the wavelength of the light when incident on the aperture 115 via the insulating film 16 will be, based on the refractive index 1.46, 534.25 nm. Furthermore, if the cutoff wavelength $\lambda_c$ of the aperture 115 is approximately 534. 25 nm or less, light of 780 nm incident from an outside source will be cut off by the aperture 115.

Here, based on the following Equation (7), if the shape of the aperture 115 is rectangular, light of 780 nm will be cut off if the long side length of the aperture is 267. 12 nm or less. Furthermore, if the aperture is elliptical in shape, based on the following Equation (8), light of 780 nm will be cut off is the radius r of the aperture is approximately 228.53 nm or less (a diameter of 457.07 nm).

$$(7) \quad \frac{\lambda_c}{2} = \frac{\lambda_{rc}}{2N} > a$$

$$(8) \quad \frac{\lambda_c}{3.413} = \frac{\lambda_{rc}}{3.413N} > r$$

In viewof this, approximate dimensions of the aperture 115 that enable visible light to pass visible light but cut off light of infrared rays (780 nm) and greater can be defined based on a cutoff wavelength $\lambda_{rc}$ that will be cut off, the refractive index $N_r$ of the insulating film 16 formed above the aperture 115, and the shape of the aperture 115.

Hereinafter, "cutoff dimension" denotes dimensions of the aperture defined by the cutoff wavelength $\lambda_{rc}$, the refractive index $N_r$ of medium formed above the aperture, and the shape of the aperture that enable light of a predetermined wavelength and greater to be cut off by the aperture. Furthermore, if the shape of the aperture is rectangular, "cutoff dimension" denotes the long side length, and if the shape is elliptical, "cutoff dimension" denotes the radius.

In addition, a cutoff dimension that enables light of a red light wavelength (610 nm) and below to pass, but cut off light of infrared rays (780 nm) and greater, is referred to as an "infrared cutoff dimension".

Note that the upper limit of the cutoff dimension is defined according to the maximum wavelength of the range of wavelengths to which a photodiode 12 is sensitive. The reason for this is that even if the dimension of aperture is greater than this upper limit, the photodiode 12 will simply receive light of a wavelength that it is unable to sense, and the result will be the same as if the light was not received at all.

For example, if the maximum wavelength is 1000 nm, the cutoff dimension of the aperture will be, based on the above Equation (7), approximately 342.46 nm if the aperture is rectangular, and approximately 200. 68 nm if the aperture is elliptical (a diameter of approximately 401.36 nm). Based on these figures, as a rough guide, the cut off dimension of the aperture 115 is approximately 500 nm. This is remarkably small compared to the conventional apertures 15, which have dimensions of 1500 nm. Hereinafter, a cutoff dimension found in such a manner is referred to as a maximum cutoff dimension.

<Spectral Characteristics of the Solid-state imaging device of the First Embodiment>

The following describes spectral characteristics of the photoelectric conversion unit 110 having the stated structure.

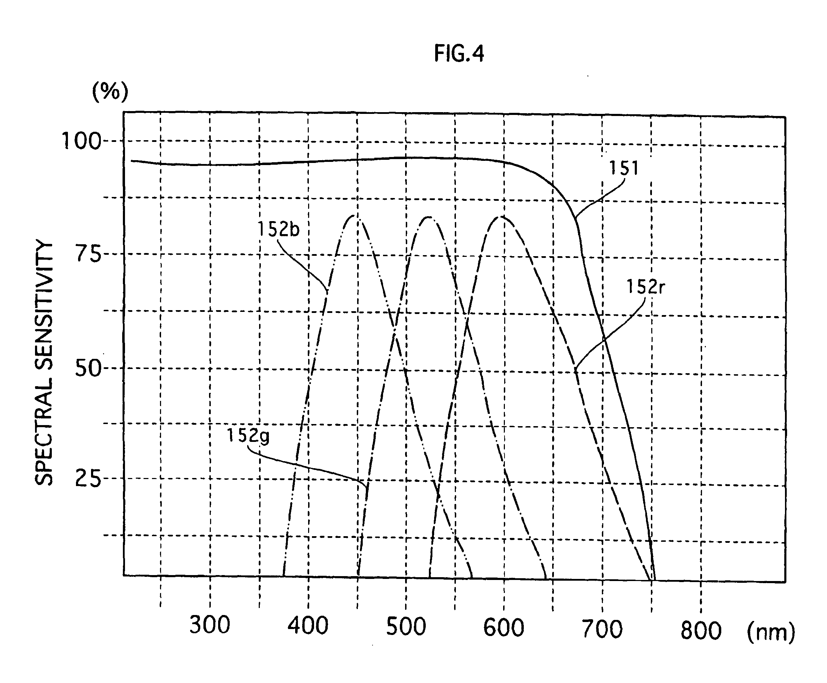

FIG. 4 is a graph showing spectral characteristics of the solid-state imaging device of the first embodiment.

Note that the horizontal axis indicates wavelength, and the vertical axis indicates spectral sensitivity.

As shown FIG. 4, a curve 151 indicates spectral characteristics of light that is able to pass through the aperture 115. For reference, a curve 152r indicates spectral characteristics of light that is able to pass through a red color filter 17r, a curve 152g indicates spectral characteristics of light that is able to pass through a green color filter 17g, and a curve 152b indicates spectral characteristics of light that is able to pass through a blue color filter 17b.

Note that in order to show characteristics of the apertures formed in the light shield film 114, the characteristics were measured with the color filters 17r, 17g and 17b removed.

As shown by the curve 151, the aperture 115 cuts off light of 760 nm and above, and enables passage of light of approximately 750 nm to 760 nm and below, where sensitivity begins to occur.

The curve 152r shows that the color filter 17r enables passage of light of a wavelength in range of 520 nm to 750 nm (hereinafter called the "R cone"), but enables almost no passage of other light. In particular, the color filter 17r enables passage of light in the vicinity of red light, as indicated by the peak of the color filter 17r being in the vicinity of the wavelength of red (610 nm).

The curve 152g shows that the color filter 17g enables passage of light of a wavelength in range of 450 nm to 640 nm (hereinafter called the "G cone"), but enables almost no passage of other light. In particular, the color filter 17g enables passage of light in the vicinity of green light, as indicated by the peak of the color filter 17g being in the vicinity of the wavelength of green (540 nm).

The curve 152b shows that the color filter 17b enables passage of light of a wavelength in range of 370 nm to 570 nm (hereinafter called "B cone"), but enables almost no passage of other light. In particular, the color filter 17b enables passage of light in the vicinity of blue light, as indicated by the peak of the color filter 17b being in the vicinity of the wavelength of blue (450 nm).

<Summary of the First Embodiment>

As described, the combination of the color filters 17r, 17g and 17b and the apertures 115 in the photoelectric conversion unit 110 enables visible light from incident light to pass through, while cutting off infrared light in the incident light. This means that light beyond the R cone that is incident on the filter 17r is cut off even without the infrared ray cut filter 18.

Note that in reality the dimensions of the aperture are defined based on approximate cutoff dimensions, by numerical analysis using the FDTD (finite difference time domain) method and experiments such as spectral measuring. However, since the apertures can only be manufactured based on a set unit of measurement, the dimensions of the aperture vary slightly.

<Other Remarks Regarding the First Embodiment>

Although an example of light of 780 nm is used here, in reality the cutoff wavelength $\lambda_{rc}$ to be cut off from light is def ined according to purpose. For example, by designing the photoelectric conversion unit 110 to be sensitive to color signals generated by the solid-state imaging device, the photoelectric conversion unit 110 may be made to receive some infrared rays, with the cutoff wavelength $\lambda_{rc}$ being set to cut off light of, for example, 790 nm or 800 nm. In particular, in an infrared camera it is important to receive light in the infrared range, and therefore the cutoff wavelength $\lambda_{rc}$ may be set so that light in the infrared range of approximately 1000 nm can be received.

Note that red (R), green (G) and blue (B) may be the three types of monochromatic light that are the primary colors in the CIE (Centre Internationale d'Eclairage) RGB color system, specifically: 700 nm (R), 546.1 nm (G) and 435.8 nm (B).

The solid-state imaging device 101 may be an MOS (metal oxide semiconductor) solid-state imaging device, an interline transfer CCD (charge coupled device) solid-state imaging device, or a frame transfer CCD solid-state imaging device.

The apertures may be elliptical in shape instead of square or rectangular.

In consideration of the influence of evanescent waves from the light shield film, the thickness of the insulating film 13 may be set at approximately the maximum wavelength in the range of waves to which the photodiode 12 is sensitive.

<Second Embodiment>

The following describes a second embodiment of the present invention with reference to the drawings. Note that structural elements having the same structure as those in the first embodiment have the same numbering thereas, and are omitted from the following description.

<Outline of the Second Embodiment>

While the main object of the first embodiment is cutting off infrared rays, the second embodiment aims to further cut off light of unnecessary wavelengths by color.

The following describes the solid-state imaging device of the second embodiment in view of the described aim.

<Structure of the Solid-state imaging device of the Second Embodiment>

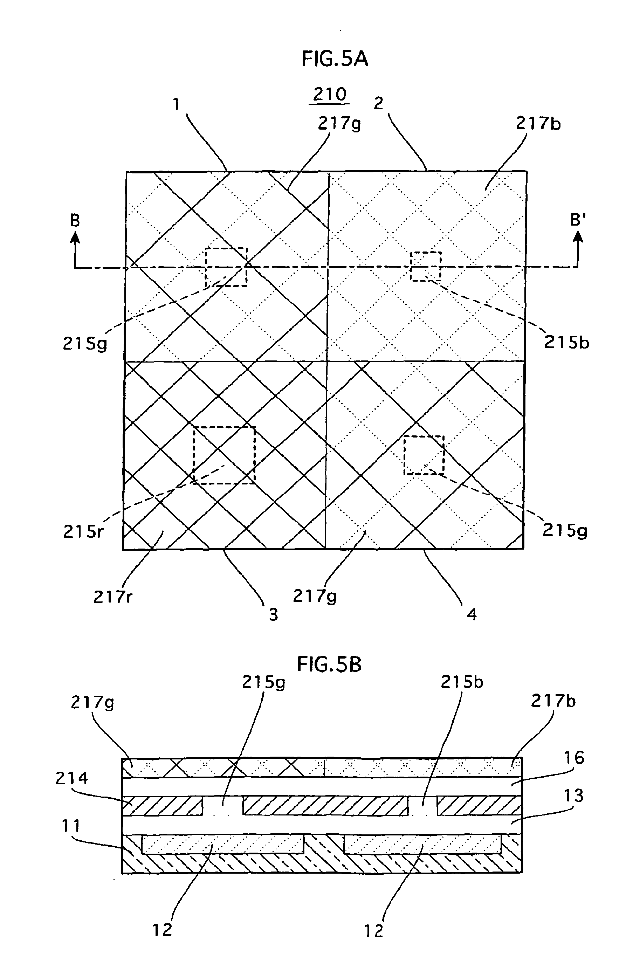

FIG. 5A shows the photoelectric conversion unit of the solid-state imaging device of the second embodiment as viewed from above, and FIG. 5B shows a cross section B-B' of the photoelectric conversion unit viewed toward an arrow direction.

Note that for brevity, only one of the pixel units (two by two pixels) among the pixel units that make up the photoelectric conversion unit 210 is shown.

As shown in FIGs. 5A and 5B, the light shield film 214 in the photoelectric conversion unit 210 is formed with apertures 215r, 215g and 215b therein, which differ from each other in dimension. The aperture 215r which has an infrared cutoff dimension is located below a color filter 217r, the aperture 215g which has a red light cut off dimension is located below a color filter 217g, and the aperture 215b which has a blue light cut off dimension is located below a color filter 217b. The insulating film 16 is sandwiched between the apertures 215r, 215g and 215b and the color filters 217r, 217g, 217b.

Here, a red light cutoff dimension indicates a cutoff dimension that will enable light of green light wave length (540 nm) and below to pass, but cut off light of red light wavelength (610 nm) and greater.

Furthermore, a green light cutoff dimension indicates a cutoff dimension that will enable light of blue light wave length (450 nm) and below to pass, but cut off light of green light wavelength (540 nm) and greater.

The infrared cutoff dimension is the largest among the dimensions, while the red light cutoff dimension is the second largest, and the green light cutoff dimension is the smallest.

<Spectral Characteristics of the Solid-state imaging device of the Second Embodiment>

The following describes spectral characteristics of the photoelectric conversion unit 210 having the stated structure.

Note that the precision of spectral characteristics of the color filters 217r, 217g and 217b is relatively low compared to the color filters 17r, 17g and 17b.

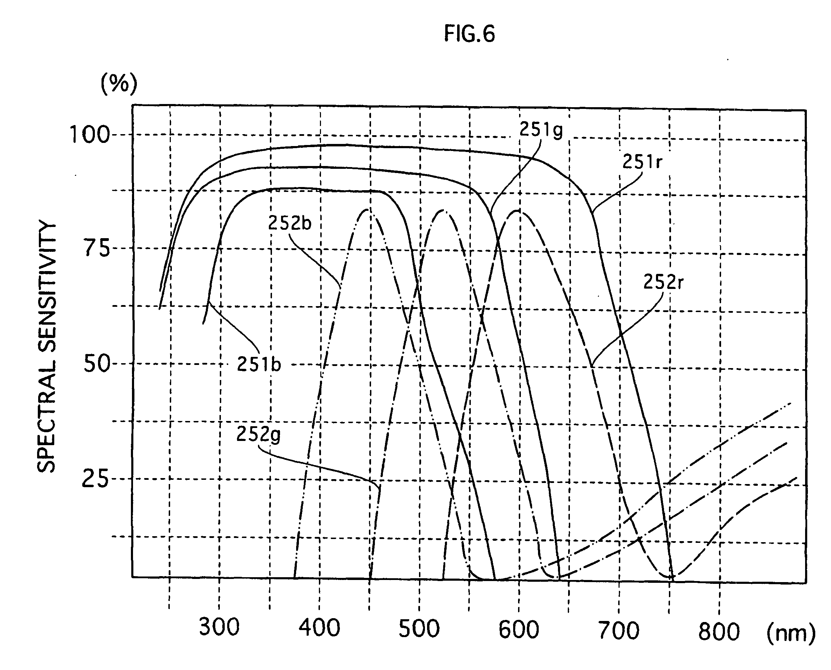

FIG. 6 is a graph showing spectral characteristics of the solid-state imaging device of the second embodiment.

In FIG. 6, a curve 251r indicates spectral characteristics of light that is able to pass through the aperture 215r, a curve 251g indicates spectral characteristics of light that is able to pass through the aperture 215g, and a curve 215b indicates spectral characteristics of light that is able to pass through the aperture 215b. For reference, a curve 252r indicates spectral characteristics of light that is able to pass through a red color filter 217r, a curve 252g indicates spectral characteristics of light that is able to pass through a green color filter 217g, and a curve 252b indicates spectral characteristics of light that is able to pass through a blue color filter 217b.

Note that in order to show characteristics of the apertures formed in the light shield film 214, the characteristics were measured with the color filters 217r, 217g and 217b removed.

As shown by the curve 251r, the aperture 215r cuts off light of 760 nm and greater, and enables passage of light of approximately 750 nm to 760 nm and below, where sensitivity begins to occur.

As shown by the curve 251g, the aperture 215g cuts off light of 650 nm and greater, and enables passage of light of approximately 630 nm to 640 nm and below, where sensitivity begins to occur.

As shown by the curve 251b, the aperture 215b cuts off light of 580 nm and greater, and enables passage of light of approximately 570 nm to 580 nm and below, where sensitivity begins to occur.

The curve 252r shows that the color filter 217r enables passage of light of a wavelength in range of 520 nm to 750 nm (R cone), but enables almost no passage of light below 520 nm. In particular, the color filter 217r enables passage of light in the vicinity of red light, as indicated by the peak of the color filter 217r being in the vicinity of the wavelength of red (610 nm). It can also be seen that the color filter 217r enables passage of light with a longer wavelength than the long wavelength-side of the R cone.

The curve 252g shows that the color filter 217g enables passage of light of a wavelength in range of 450 nm to 630 nm (G cone), but enables almost no passage of below 450 nm. In particular, the color filter 217g enables passage of light in the vicinity of green light, as indicated by the peak of the color filter 217g being in the vicinity of the wavelength of green (540 nm). It can also be seen that the color filter 217g enables passage of light with a longer wavelength than the long wavelength-side of the G cone.

The curve 252b shows that the color filter 217b enables passage of light of a wavelength in range of 370 nm to 560 nm (B cone), but enables almost no passage of light below 370 nm. In particular, the color filter 217b enables passage of light in the vicinity of blue light, as indicated by the peak of the color filter 217b being in the vicinity of the wavelength of blue (450 nm). It can also be seen that the color filter 217b enables passage of light with a longer wavelength than the long wavelength-side of the B cone.

<Summary of the Second Embodiment>

As described, the apertures 215r, 215g and 215b function as high pass filters that cut off light that is unnecessary when reproducing light of the respective colors.

For example, the combination of the color filter 217r and the aperture 215r enables light in the vicinity of red light wavelength to pass, while cutting off light of infrared wavelength and greater. This means that, as shown by the curves 251rand252r, even if the wavelength range of incident light of the color filter 217r is longer than the wavelength of the R cone, light that exceeds 760 nm is cut off by the aperture 215r. Furthermore, this enables spectral characteristics close to those shown by the curve 152r in FIG. 4 to be achieved.

Similarly, as shown by the curves 251g and 252g, the combination of the color filter 217g and the aperture 215g enables light in the vicinity of green light wavelength topass, while cutting of f light of red wavelength and greater. This enables spectral characteristics close to those shown by the curve 152g in FIG. 4 to be achieved.

Furthermore, as shown by the curves 251b and 252b, the combination of the color filter 217b and the aperture 215b enables light in the vicinity of blue light wavelength to pass, while cutting off light of green wavelength and greater. This enables spectral characteristics close to those shown by the curve 152b in FIG. 4 to be achieved.

<Other Remarks Regarding the Second Embodiment>

The apertures may be given differing shapes according to the color assigned to the pixel.

<Third Embodiment>

The following describes a third embodiment of the present invention with reference to the drawings. Note that structural elements having the same structure as those in the second embodiment have the same numbering thereas, and are omitted from the following description.

<Outline of the Third Embodiment>

While the main object of the second embodiment is to cut off light of unnecessary wavelengths by color, the third embodiment aims to increase sensitivity, which is decreases due to the apertures being made smaller in order to cut off unnecessary light.

The following describes the solid-state imaging device of the third embodiment in view of the described aim.

<Structure of the Solid-state imaging device of the Third Embodiment>

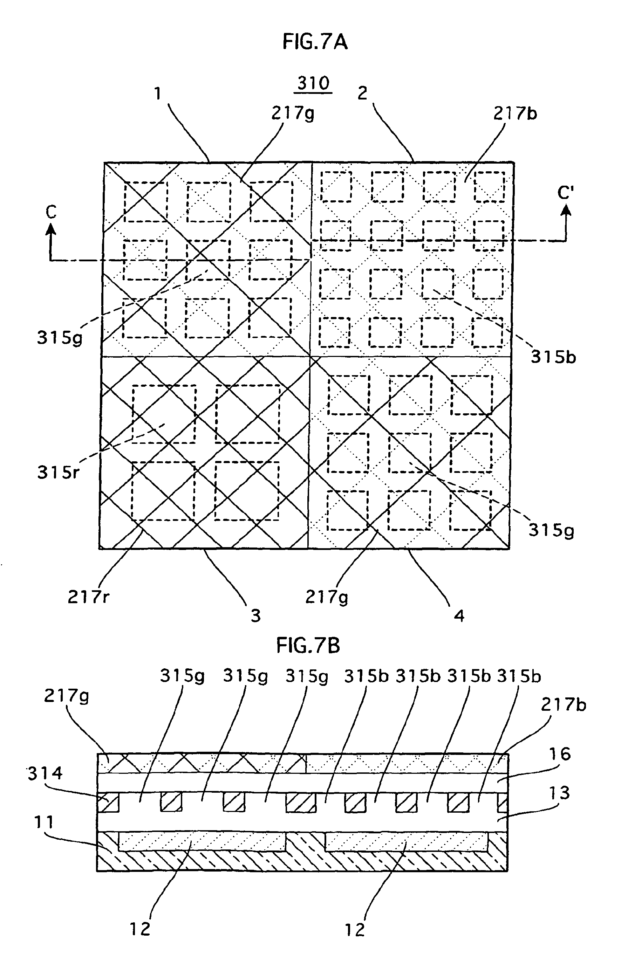

FIG. 7A shows the photoelectric conversion unit of the solid-state imaging device of the third embodiment as viewed from above, and FIG. 7B shows a cross section C-C' of the photoelectric conversion unit viewed toward an arrow direction.

Note that for brevity, only one of the pixel units (two by two pixels) among the pixel units that make up the photoelectric conversion unit 310 is shown.

As shown in FIGs. 7A and 7B, the light shield film 314 in the photoelectric conversion unit 310 is formed with apertures 315r, 315g and 315b, which differ from each other in dimension . The apertures 3 15r which have infrared cutoff dimensions are arranged with even intervals therebetween below the color filter 217r. Similarly, the apertures 315g which have red cutoff dimensions are arranged even with intervals therebetween below the color filter 217g, and the apertures 315b which have green cutoff dimensions are arranged even intervals therebetween below the color filter 217b. The insulating film 16 is sandwiched between the apertures 315r, 315g and 315b and the color filters 217r, 217g, 217b.

The drawing shows an example in which four apertures 315r are arranged with even intervals therebetween below the color filter 217r, nine apertures 315g are arranged with even intervals therebetween below the color filter 217g, and sixteen apertures 315b are arranged with even intervals therebetween below the color filter 217b.

By reducing the distance between apertures, the number of apertures that can be provided in the pixel unit increases , thereby increasing area occupied by the apertures and, consequently, sensitivity. However, when the distance between the apertures is reduced, light of long wavelength passes through more easily. For this reason, if the distance between neighboring apertures is to be set with priority given to sensitivity, the apertures are formed in the light shield film 314 so that the distance therebetween is smaller than the corresponding cutoff dimension. On the other hand, if the distance between neighboring apertures is to be set so as to prevent mixing of light of long wavelength, the apertures are formed so that the distance therebetween is larger than the corresponding cutoff dimension. In other words, the distance between the apertures is determined according purpose.

<Summary of the Third Embodiment>

As described, by providing two or more apertures above each photodiode 12, the amount of light able to be received by the photodiodes increases, and sensitivity increases considerably.

<Other Remarks Regarding the Third Embodiment>

Note that the thickness of the insulating film 13 may be set to be approximately the same as the infrared cutoff dimension if influence of attenuating light in the apertures 315r is to be reduced, or may be set to be approximately the same as the green cutoff dimension if influence of attenuating light in the apertures 315b is to be reduced.

<Fourth Embodiment>

The following describes a fourth embodiment of the present invention with reference to the drawings. Note that structural elements having the same structure as those in the third embodiment have the same numbering thereas, and are omitted from the following description.

<Outline of the Fourth Embodiment>

While the main object of the third embodiment is to increase sensitivity which decreases due to the apertures being made smaller, the fourth embodiment aims to adjust spectral characteristics of light that passes through the apertures provided in each pixel, by forming apertures of at least two different cutoff dimensions in the light shield film belonging to each pixel.

The following describes the solid-state imaging device of the fourth embodiment in view of the described aim.

<Structure of the Solid-state imaging device of the Fourth Embodiment>

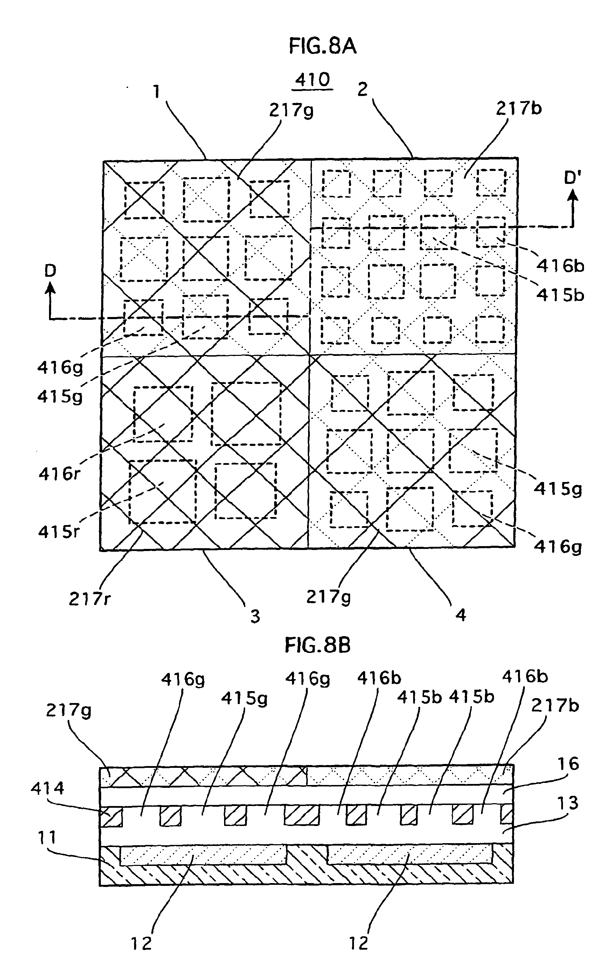

FIG. 8A shows the photoelectric conversion unit of the solid-state imaging device of the fourth embodiment as viewed from above, and FIG. 8B shows a cross section D-D' of the photoelectric conversion unit viewed toward an arrow direction.

Note that for brevity, only one of the pixel units (two by two pixels) among the pixel units that make up the photoelectric conversion unit 410 is shown.

As shown in FIGs. 8A and 8B, the light shield film 414 in the photoelectric conversion unit 410 is formed with respective combinations of apertures 415r, 415g and 415b, which differ from each other in cutoff dimension, and apertures 416r, 416g and 416b, which also differ from each other in cutoff dimension. The apertures 415r and the apertures 416r which have infrared cutoff dimensions are arranged with set intervals therebetween below the color filter 217r. Similarly, the apertures 415g and the apertures 416g which have red cutoff dimensions are arranged with set intervals therebetween below the color filter 217g, and the apertures 415b and the apertures 416b which have green cutoff dimensions are arranged with set intervals therebetween below the color filter 217b. The insulating film 16 is sandwiched between the apertures 415r, 415g, 415b, 416r, 416b and 416g and the color filters 217r, 217g, 217b.

The dimensions of the apertures are determined according to purpose. If the apertures 416r are to be set so as to give priority to sensitivity, they should be larger than the apertures 415r. Furthermore, if the apertures 416r are to be set so as to prevent mixing of light of long wavelength, the apertures 416r should be smaller than the apertures 415r. Similarly, the size of the apertures 416g can be determined according to purpose, based on the size of the apertures 415g, and the size of the apertures 416b can be determined according to purpose, based on the size of the apertures 415b.

For example, as shown in the drawing, two apertures 415r, and two apertures 416r that are slightly smaller than the apertures 415r are provided below the color filter 217r at set intervals. Similarly, five apertures 415g, and four apertures 416g that are slightly smaller than the apertures 415g are provided below the color filter 217g at set intervals. Furthermore, four apertures 415b, and twelve apertures 416b that are slightly smaller than the apertures 415b are provided below the color filter 217b at set intervals.

<Spectral Characteristics of the Solid-state imaging device of the Fourth Embodiment>

The following describes spectral characteristics of the photoelectric conversion unit 410 having the stated structure.

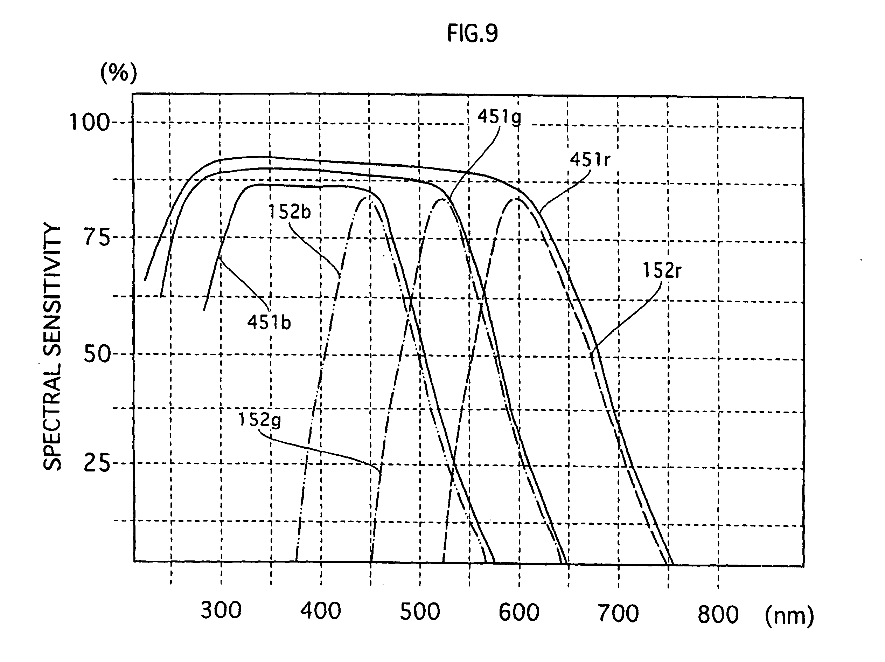

FIG. 9 is a graph showing spectral characteristics of the solid-state imaging device of the fourth embodiment.

In FIG. 9, a curve 451r indicates spectral characteristics of light that is able to pass through the apertures 415r and 416r, a curve 451g indicates spectral characteristics of light that is able to pass through the apertures 415g and 416g, and a curve 451b indicates spectral characteristics of light that is able to pass through the apertures 415b and 416b. For reference, the curves 152r, 152g, and 152b shown in FIG. 4 are shown in FIG. 9 also.

Note that in order to show characteristics of the apertures formed in the light shield film 414, the characteristics were measured with the color filters 217r, 217g and 217b removed.

As shown by the curve 451r, the combination of the apertures 415r and 416r cuts off light of 760 nm and greater, and enables passage of light of approximately 750 nm to 760 nm and below, where sensitivity begins to occur, in a shape that follows the part of the curve of the long wavelength-side of the R cone.

As shown by the curve 451g, the combination of the apertures 415g and 416g cuts off light of 650 nm and greater, and enables passage of light of approximately 630 nm to 640 nm and below, where sensitivity begins to occur, in a shape that follows the part of the curve of the long wavelength-side of the G cone.

As shown by the curve 451b, the combination of the apertures 415b and 416b cuts off light of 580 nm and greater, and enables passage of light of approximately 570 nm to 580 nm and below, where sensitivity begins to occur, in a shape that follows the part of the curve of the long wavelength-side of the B cone.

<Summary of the Fourth Embodiment>

As described, the combination of the color filter 217r, the apertures 415r and the apertures 416r enables light in the vicinity of red light wavelength to pass, while cutting off light of infrared wavelength and beyond. Furthermore, since the sensitivity and mixing of long wavelength light are adjusted according to the apertures 416r, spectral characteristics close to those shown by the curve 152r in FIG. 4 can be achieved.

Similarly, the combination of the color filter 217g, the apertures 415g and the apertures 416g enables light in the vicinity of green light wavelength to pass, while cutting of light of red wavelength and beyond. Furthermore, since the sensitivity and mixing of long wavelength light are adjusted according to the apertures 416g, spectral characteristics close to those shown by the curve 152g in FIG. 4 can be achieved.

Furthermore, the combination of the color filter 217b, the apertures 415b and the apertures 416b enables light in the vicinity of blue light wavelength to pass, while cutting off light of green wavelength and beyond. Furthermore, since the sensitivity and mixing of long wavelength light are adjusted according to the apertures 416b, spectral characteristics close to those shown by the curve 152b in FIG. 4 can be achieved.

<Other Remarks Regarding the Fourth Embodiment>

The dimensions of the each of the apertures 415r and 416r may be slightly smaller or slightly larger than the infrared ray cutoff dimensions. Similarly, the dimensions of the each of the apertures 415g and 416g may be slightly smaller or slightly larger than the red light cutoff dimensions, and the dimensions of the each of the apertures 415b and 416b may be slightly smaller or slightly larger than the green light cutoff dimensions.

Note that the thickness of the insulating film 13 may be set to be approximately the same as the infrared cutoff dimension if influence of attenuating light in the apertures 415r is to be reduced, or may be set to be approximately the same as the green cutoff dimension if influence of attenuating light in the apertures 416b is to be reduced.

Combinations of rectangular apertures having the same long side dimensions and elliptical apertures having the same diameters may be used. Alternatively, combinations of rectangular apertures having different long side dimensions and elliptical apertures having different diameters may be used.

<Fifth Embodiment>

The following describes a fifth embodiment of the present invention with reference to the drawings. Note that structural elements having the same structure as those in the first embodiment have the same numbering thereas, and are omitted from the following description.

<Outline of the Fifth Embodiment>

While the first embodiment focuses on separating polarized components of incident light, the fifth embodiment aims to separate polarized components of incident light by forming the apertures in rectangular shapes, and varying the dimensions of the shorter sides thereof.

The following describes the solid-state imaging device of the fifth embodiment in view of the described aim.

<Structure of the Solid-state imaging device of the Fifth Embodiment>

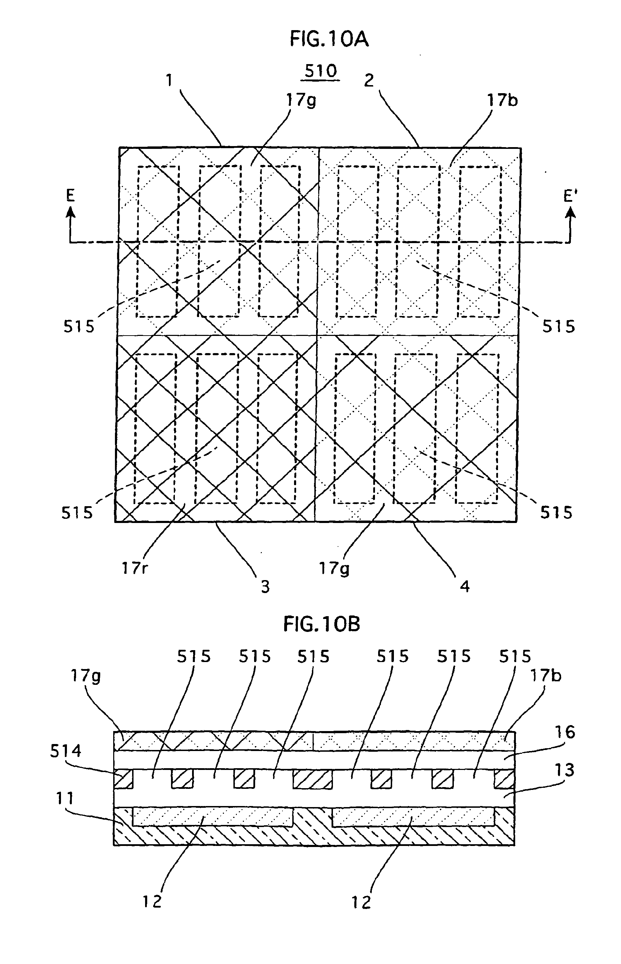

FIG. 10A shows the photoelectric conversion unit of the solid-state imaging device of the fifth embodiment as viewed from above, and FIG. 10B shows a cross section E-E' of the photoelectric conversion unit viewed toward an arrow direction.

Note that for brevity, only one of the pixel units (two by two pixels) among the pixel units that make up the photoelectric conversion unit 510 is shown.

As shown in FIGs . 10A and 10B, long, narrow rectangular apertures 515 are formed in the light shield film 514 of the photoelectric conversion unit 510.

<Electromagnetic Waves in a Waveguide>

The following describes electromagnetic waves in a rectangular waveguide, with the apertures 515 with long sides a and short sides b as the waveguide. Note that it is assumed that the walls of the rectangular waveguide are made of a perfect conductor, and that the waveguide is filled with an isotropic, homogenous medium having a permittivity $\varepsilon$ and a permeability $\mu$.

It is commonly known that electromagnetic waves propagated in rectangular waveguides are TE waves (transverse electric waves) or TM waves (transverse magnetic waves).

Here, TE waves (also called H waves) are electromagnetic waves of which the electric field of the propagation direction is zero, and TM waves (also called E waves) are electromagnetic waves of which the magnetic field of the propagation direction is zero.

The following describes TE waves and then TM waves. Here, a direction along the long sides a of the waveguide is called the x direction, a direction along the short sides b of the waveguide is called the y direction, and a direction in which the TE waves or the TM waves are propagated in the waveguide is called the z direction. The electromagnetic field components in each direction are denoted as $E_x$, $E_y$, $E_z$, $H_x$, $H_y$, and $H_z$, the angular frequency is represented by $\omega$, and the wave number in the z direction is represented $\gamma$.

<TE waves>

When the electromagnetic waves propagated in the waveguide are TE waves, the magnetic field component $H_z$ in the Z direction fulfills a wave equation shown by the following Equation (9).

$$(9) \begin{cases} \dfrac{\partial^2 H_z}{\partial x^2} + \dfrac{\partial^2 H_z}{\partial y^2} + k_c^2 H_z = 0 \\[2em] k_c^2 = \omega^2 \varepsilon\mu - \gamma^2 \end{cases}$$

$$(10) \begin{cases} \dfrac{\partial H_z}{\partial x} = 0 & (x = 0, a) \\[2em] \dfrac{\partial H_z}{\partial y} = 0 & (y = 0, b) \end{cases}$$

$$(11) \begin{cases} H_z = (A\cos\alpha x + B\sin\alpha x)(C\cos\beta y + D\sin\beta y)\exp(-i\gamma z) \\[1.5em] B = 0 \quad , \quad \sin\alpha a = 0 \\[1.5em] D = 0 \quad , \quad \sin\beta b = 0 \\[1.5em] \alpha = \dfrac{m\pi}{a} \quad , \quad \beta = \dfrac{n\pi}{b} \end{cases}$$

Furthermore, the electromagnetic field component in the cross section of the waveguide is shown by Equation (12). This is found from ($H_z$) of Equation (11), which is found by solving Equation (9) under Equation (10) which shows a boundary condition that the tangent component of the electric field must zero with respect to the perfectly conductive wall. Note that $m$ and $n$ are non-negative integers that are not zero simultaneously.

$$(1\,2)\begin{cases} E_x = i\,\dfrac{\omega\mu}{k_c{}^2}\,\dfrac{n\pi}{b}\,H_0\cos\dfrac{m\pi x}{a}\sin\dfrac{n\pi y}{b}\,e^{-i\gamma z} \\[2mm] E_y = -i\,\dfrac{\omega\mu}{k_c{}^2}\,\dfrac{m\pi}{a}\,H_0\sin\dfrac{m\pi x}{a}\cos\dfrac{n\pi y}{b}\,e^{-i\gamma z} \\[2mm] E_z = 0 \\[2mm] H_x = i\,\dfrac{\gamma}{k_c{}^2}\,\dfrac{m\pi}{a}\,H_0\sin\dfrac{m\pi x}{a}\cos\dfrac{n\pi y}{b}\,e^{-i\gamma z} \\[2mm] H_y = i\,\dfrac{\gamma}{k_c{}^2}\,\dfrac{n\pi}{b}\,H_0\cos\dfrac{m\pi x}{a}\sin\dfrac{n\pi y}{b}\,e^{-i\gamma z} \\[2mm] H_z = H_0\cos\dfrac{m\pi x}{a}\cos\dfrac{n\pi y}{b}\,e^{-i\gamma z} \end{cases}$$

Hereinafter, the eigen mode belonging to TE waves is called TE mode or H mode, and the eigen mode corresponding to $m$ and $n$ is called $TE_{nm}$ mode or $H_{nm}$ mode.
Here, eigen mode denotes the group of $E_x$, $E_y$, $E_z$, $H_x$, $H_y$, and $H_z$. Furthermore, the eigen value(or cutoff constant) with respect to the eigen mode is called $k_c$.

<TM waves>

When the electromagnetic waves propagated in the waveguide are TM waves, the electric field component $E_z$ in the Z direction fulfills a wave equation shown by the following Equation (13).

$$(1\,3)\begin{cases} \dfrac{\partial^2 E_z}{\partial x^2} + \dfrac{\partial^2 E_z}{\partial y^2} + k_c{}^2 E_z = 0 \\[3mm] k_c{}^2 = \omega^2\varepsilon\mu - \gamma^2 \end{cases}$$

$$(1\,4)\qquad E_z = 0 \qquad\qquad (\,x = 0,\,a\ or\ y = 0,\,b\,)$$

$$(15)\begin{cases} E_z = (A\cos\alpha x + B\sin\alpha x)(C\cos\beta y + D\sin\beta y)\exp(-i\gamma z) \\ \\ A = 0 \quad, \quad \sin\alpha a = 0 \\ \\ C = 0 \quad, \quad \sin\beta b = 0 \\ \\ \alpha = \dfrac{m\pi}{a} \quad, \quad \beta = \dfrac{n\pi}{b} \end{cases}$$

Furthermore, the electromagnetic field component in the cross section of the waveguide is shown by Equation (16). This is found from $(E_z)$ of Equation (15), which is found by solving Equation (13) under Equation (14) which shows a boundary condition that the electric field is zero at the perfectly conductive wall. Note that $m$ and $n$ are positive integers.

$$(16)\begin{cases} E_x = -i\dfrac{\gamma}{k_c^2}\dfrac{m\pi}{a}Eo\cos\dfrac{m\pi x}{a}\sin\dfrac{n\pi y}{b}e^{-i\gamma z} \\ \\ E_y = -i\dfrac{\gamma}{k_c^2}\dfrac{n\pi}{b}Eo\sin\dfrac{m\pi x}{a}\cos\dfrac{n\pi y}{b}e^{-i\gamma z} \\ \\ E_z = Eo\sin\dfrac{m\pi x}{a}\sin\dfrac{n\pi y}{b}e^{-i\gamma z} \\ \\ H_x = i\dfrac{\omega\varepsilon}{k_c^2}\dfrac{n\pi}{b}Eo\sin\dfrac{m\pi x}{a}\cos\dfrac{n\pi y}{b}e^{-i\gamma z} \\ \\ H_y = -i\dfrac{\omega\varepsilon}{k_c^2}\dfrac{m\pi}{a}Eo\cos\dfrac{m\pi x}{a}\sin\dfrac{n\pi y}{b}e^{-i\gamma z} \\ \\ H_z = 0 \end{cases}$$

Hereinafter, the eigen mode belonging to TM waves is called TM mode or E mode, and the eigen mode corresponding to $m$ and $n$ is called $TM_{nm}$ mode or $E_{nm}$ mode.

<Transmission Characteristics of the Waveguide>

The following described transmission characteristics of the waveguide.

The cutoff wavelength $\lambda_{c(mn)}$ of the $TE_{nm}$ mode and the $TM_{nm}$ mode in the rectangular waveguide are shown by the following Equation (17) . As shown by Equation (17), light that is below the cutoff wavelength $\lambda_{c(mn)}$ defined for each eigen mode is able to pass through the apertures 515. Consequently, the apertures 515 are considered to be multi-modal.

Here, multi-modal waveguide denotes a waveguide used in an area in which propagation is possible in a plurality of modes.

$$(1 7) \quad \lambda_{c(mn)} = \frac{2}{\sqrt{\left(\frac{m}{a}\right)^2 + \left(\frac{n}{b}\right)^2}}$$

However, even if light of a higher mode passes through the apertures 515, if the wavelength is- below the shortest wavelength (270 nm) in the wavelength range to which the photodiode is sensitive, the light will not be sensed by the photodiode, and the result will be the same as if the light had not passed through the aperture 515 at all.

Here, higher mode denotes an eigen mode other than the eigen mode in which the cutoff wavelength is longest. The eigen mode in which the cutoff wavelength is longest is referred to as the dominant mode hereinafter.

In Equation (17), $n$ and $m$ are positive integers that are not zero simultaneously in the case of TE mode, and are positive integers in the case of TM mode. As shown by Equation (18), TE10 is the dominant mode when a relationship a>b is fulfilled by the long side $a$ and the short side $b$. Furthermore, Equation (18) shows that light (electromagnetic waves) propagated in the waveguide in the dominant mode is limited to being components in one direction.

$$(1 8) \begin{cases} E_x = 0 \\ \\ E_y = -i \dfrac{\omega\mu}{k_c^2} \dfrac{\pi}{a} H_0 \sin \dfrac{\pi x}{a} e^{-i\gamma z} \\ \\ E_z = 0 \\ \\ H_x = i \dfrac{\gamma}{k_c^2} \dfrac{\pi}{a} H_0 \sin \dfrac{\pi x}{a} e^{-i\gamma z} \\ \\ H_y = 0 \\ \\ H_z = H_0 \cos \dfrac{\pi x}{a} e^{-i\gamma z} \end{cases}$$

For this reason, in Equation (17), if the short side b is set so as to be less than the shortest wavelength of light able to pass through the aperture 515 in a first higher mode, the photodiode receives only light in the dominant mode, and therefore the waveguide can be considered to be a single-mode waveguide. In addition, polarized components of incident light can be separated.

Suppose, for example, that a relationship shown by Equation (19) using a coefficient is satisfied by the higher mode cutoff wavelength $\lambda_{c(mn)}$ and the dominant mode cutoff wavelength $\lambda_{c(10)}$. If a long side a of the rectangular waveguide is used, the dominant mode cutoff wavelength $\lambda_{c(10)}$ is shown by the following Equation (20). Furthermore, if Equation (19) and Equation (20) are substituted in Equation (17), a relational equation shown by the following Equation (21) is derived between the short side $b$ and the long side a of the rectangular waveguide.

$$(1 9) \quad \lambda_{c(mn)} = \alpha \lambda_{c(10)}$$

$$(20) \qquad \lambda_{c(10)} = 2a$$

$$(21) \qquad b = \sqrt{\dfrac{n^2\alpha^2}{1 - m^2\alpha^2}}\, a$$

For example, in a case in which incident light below infrared rays (780 nm) from an external source passes through the aperture 515 via the insulating film 16, taking into account the refractive index ($N_r$=1.46), if $\lambda_{c(10)}$ is 780 nm, $\lambda_{c(11)}$ is 390 nm, and these are substituted in Equations (19) and (20) respectively, the aperture 515 functions as a single-mode waveguide in a range of at least 390 nm and less than 780 nm if the long side a of the aperture 515 is approximately 267.12 nm, and the short side *b* is less than approximately 154.22 nm. Furthermore, in a case in which incident light below red wavelength (610 nm) passes through the aperture 515, the aperture 515 functions as a single-mode waveguide in a range of at least 390 nm and less than 610 nm, if the long side a of the aperture 515 is approximately 208.90 nm, and the short side b is less than approximately 173.70 nm. Similarly, in a case in which incident light below green wavelength (540 nm) passes through the aperture 515, the aperture 515 functions as a single-mode waveguide in a range of at least 390 nm and less than 540 nm, if the long side a of the aperture 515 is approximately 184.93 nm, and the short side b is less than approximately 184.93 nm. In addition, in a case in which incident light below blue wavelength (450 nm) passes through the aperture 515, the aperture 515 functions as a single-mode waveguide in a range of at least 390 nm and less than 450 nm, if the long side a of the aperture 515 is approximately 154.11 nm, and the short side b is less than approximately 154.11 nm.

<Summary of the Fifth Embodiment>

As described, the polarized components of light that has an electric field corresponding to the long side dimension of the aperture is collected in the photodiode 12 by forming the aperture with a long, narrow rectangular shape. This is because light having an electric field in the long side direction of the aperture generally passes through the aperture more easily than light having an electric field in the short side direction. This enables the polarized component of incident light to be separated according the short side dimension of the aperture, and consequently enables realization of high picture quality because false signals caused by diffused reflection of light are prevented and the photodiode 12 receives only desired polarized light, and mixing of color signals is further prevented and polarization accuracy is heightened.

<Other Remarks Regarding the Fifth Embodiment>

Note that the apertures 515 may all have a same type of long side dimension, either an infrared ray cutoff dimension, a red light cutoff dimension, or a green light cutoff dimension. Alternatively, each type of pixel may be provided with a different one of three types of aperture 515, each having different dimensions. As a result, in the photoelectric conversion unit 510, selectivity of polarized light is improved and three types of color signal (the three primary colors) are generated, as in the photoelectric conversion unit 210 described in the second embodiment.

The light shield film 514 may be formed with two types of apertures therein which are arranged above the photodiode 12 such that respective long sides are oriented in different directions. This enables the photo-sensor 12 to receive light having different polarized components.

A plurality of apertures may be formed with respect to each aperture, as in the photoelectric conversion unit 310 described in the third embodiment.

Furthermore, a plurality of apertures of two different types may be formed, as in the photoelectric conversion unit 410 described in the third embodiment. Here, the short side dimension may be either the same or different for each aperture.

<Sixth Embodiment>

The following describes a sixth embodiment of the present invention with reference to the drawings. Note that structural elements having the same structure as those in the second embodiment have the same numbering thereas, and are omitted from the following description.

<Outline of the Sixth Embodiment>

The main object of the second embodiment is to cut off light that is unnecessary when reproducing each of the colors from among the light that passes through the color filters 217r, 217g and 217b by using three types of apertures that have respectively different cutoff dimensions. In contrast, the sixth embodiment aims to generate RGB format signals necessary when reproducing each color, by applying signal processing to electric signals obtained by photoelectric converting light that has passed through three types of apertures that have respectively different cutoff dimensions. This is instead of the color filters 217r, 217g and 217b which are not present in the sixth embodiment.

The following describes the solid-state imaging device of the sixth embodiment in view of the described aim.

< Solid-state imaging device of the Sixth Embodiment>

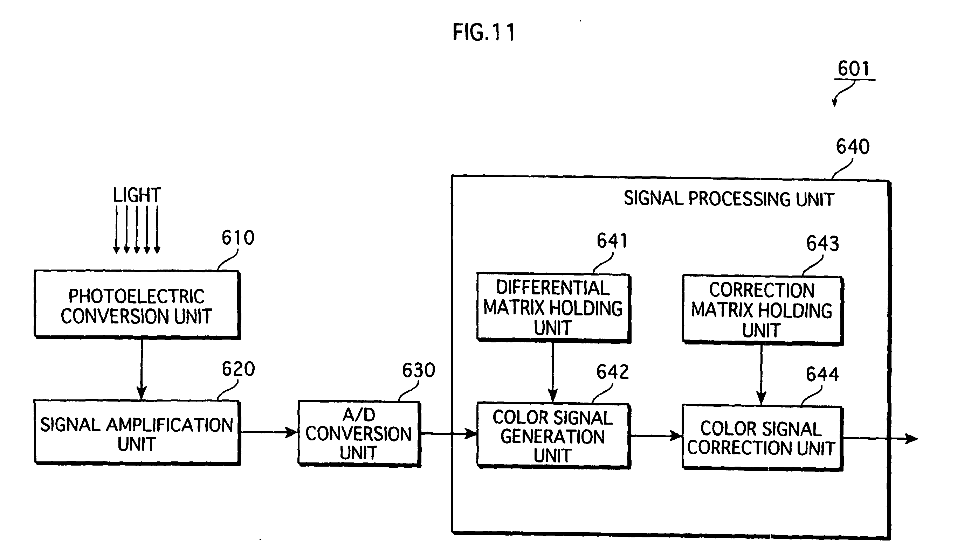

FIG. 11 is a functional block diagram showing the structure of the solid-state imaging device of the sixth embodiment.

As shown in the figure, a solid-state imaging device 601 is composed of a photoelectric conversion unit 610, a signal amplification unit 620, an A/D conversion unit 630, and a signal processing unit 640.

The photoelectric conversion unit 610 is the photoelectric conversion unit 210 of the second embodiment from which the color filters have been omitted. The photoelectric conversion unit 610 outputs electric signals photoelectrically converted from light that has passed through the apertures of differing cutoff dimensions to the signal amplification unit 620.

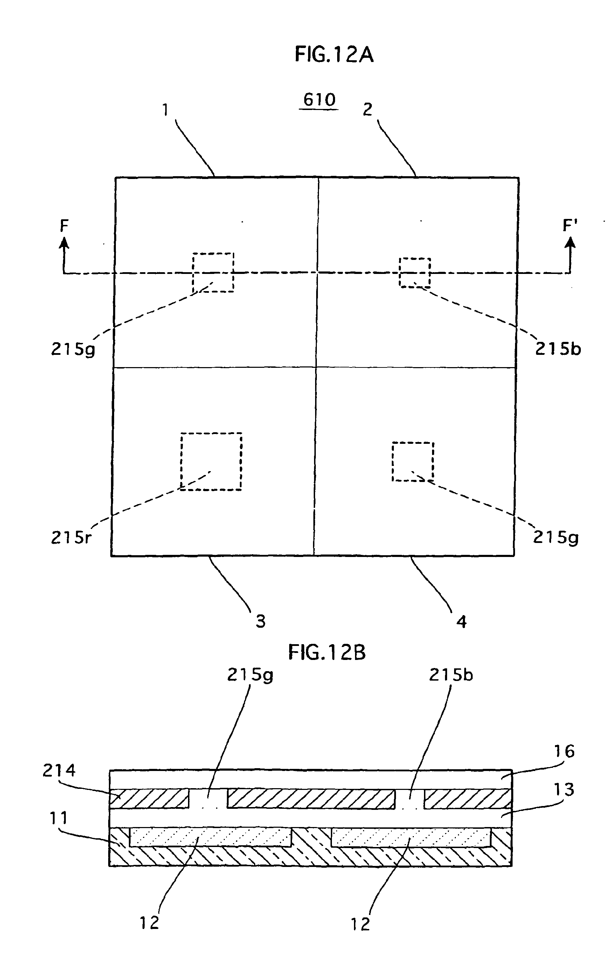

FIG. 12A shows the photoelectric conversion unit of the solid-state imaging device of the sixth embodiment as viewed from above, and FIG. 12B shows a cross section F-F' of the photoelectric conversion unit viewed toward an arrow direction.

Note that for brevity, only one of the pixel units (two by two pixels) among the pixel units that make up the photoelectric conversion unit 610 is shown.

As shown in FIGs. 12A and 12B, the photoelectric conversion unit 610 differs from the photoelectric conversion unit 210 in that the color filters 217r, 217g and 217b that are provided above the apertures 215r, 215g and 215b of differing cutoff dimensions with the insulating film 16 therebetween are omitted in the photoelectric conversion unit 610. Note that it is possible to omit the insulating film 16 from the photoelectric conversion unit 610.

In the following, $L_{IC}$ represents an electrical signal generated according to photoelectric conversion by a photodiode above which an aperture having an infrared ray cutoff dimension is provided, $L_{RC}$ represents an electrical signal generated according to photoelectric conversion by a photodiode above which an aperture having a red light cutoff dimension is provided, and $L_{GC}$ represents an electrical signal generated according to photoelectric conversion by a photodiode above which an aperture having a green light cutoff dimension is provided. Furthermore, the signals output by the photoelectric conversion unit 610 to the signal amplification unit 620 are expressed as $L_{IC}$, $L_{RC}$, and $L_{GC}$ respectively.

The signal amplification unit 620 is an amplifier that amplifies signals. The signal amplification unit 620 amplifies each signal output by the photoelectric conversion unit 610 ($L_{IC}$, $L_{RC}$, $L_{GC}$), and outputs each amplified signal to the A/D conversion unit 630.

Here, the signal generated by amplifying $L_{IC}$ is called $AL_{IC}$, the signal generated by amplifying $L_{RC}$ is called $AL_{RC}$, and the signal generated by amplifying $L_{GC}$ is called $AL_{GC}$. Furthermore, the signals output by the signal amplification unit 620 to the A/D conversion unit 630 are expressed as $AL_{IC}$, $AL_{RC}$, and $AL_{GC}$ respectively.

The A/D conversion unit 630 is an A/D converter that converts analog signals into digital signals. The A/D conversion unit 630 converts each signals output by the signal amplification unit 620 ($AL_{IC}$, $AL_{RC}$, $AL_{GC}$) into a digital signal and outputs each digital signal to the signal processing unit 640.

Here, the digital signal generated by converting $AL_{IC}$ is called $DL_{IC}$, the digital signal generated by converting $AL_{RC}$ is called $DL_{RC}$, and the digital signal generated by converting $AL_{GC}$ is called $DL_{GC}$. Furthermore, the signals output by the A/D conversion unit 630 to the signal processing unit 640 are expressed as $DL_{IC}$, $DL_{RC}$, and $DL_{GC}$ respectively.

The signal processing unit 640 is a DSP (digital signal processor) that processes digital signals. The signal processing unit 640 converts each digital signal output by the A/D conversion unit ($DL_{IC}$, $DL_{RC}$, $DL_{GC}$) into a red signal, a green signal, or a blue signal indicated by the RGB color system, and outputs each color signal.

Here, red, green, and blue signals indicated by the RGB color system and generated by converting $DL_{IC}$, $DL_{RC}$, and $DL_{GC}$ according to differential processing, correction processing and the like are indicated by R, G, and B respectively. Furthermore, signals output by the signal processing unit 640 are expressed by R, G and B respectively.

<Detailed Structure of the Signal Processing Unit>

The signal processing unit 640 is composed of a differential matrix holding unit 641, a color signal generation unit 642, a correction matrix holding unit 643 and a color signal correction unit 644.

The differential matrix holding unit 641 holds a matrix composed of differential coefficients (hereinafter called a "differential matrix").

Here, each differential coefficient is a coefficient indicating that a color signal has been generated by taking a differential for one of the signals $DL_{IC}$, $DL_{RC}$ and $DL_{GC}$.

The color signal generation unit 642 applies a matrix operation based on the differential matrix, thereby converting the signals input into the signal processing unit 640 ($DL_{IC}$, $DL_{RC}$, $DL_{GC}$) into color signals (R, G, B).

The correction matrix holding unit 643 holds a matrix composed of correction coefficients (hereinafter called a "correction matrix").

Here, each correction coefficient indicates that color correction has been performed on one of the color signals (R, G, B).

The color signal correction unit 644 applies a matrix operation based on the correction matrix, thereby correcting each color signal that was converted by the color signal generation unit 642 (R, G, B) into an ideal color signal. Note that color correction is that which is used in color televisions, color photography and the like, and therefore details are not described here.

If the type of color signal in the RGB color system is expressed as M, and the type of signal input into the signal processing unit 640 is expressed as N, the differential matrix is shown by an M by N matrix, and the correction matrix is shown by an M by M matrix.

<Differential Matrix Example>

The following describes an example of the structure of the differential matrix. Note that it is assumed here that the following five conditions are fulfilled.

(1) Light received by the photodiodes is light standardized to specific wavelengths.
(2) The wavelength and the amount of the light differs according to the dimensions of the apertures provided above the photodiodes.
(3) The standardized light is obtained according to an additive process of red light, green light and blue light.
(4) Electric signals obtained by photoelectric conversion by the photodiodes are specified according to the wavelength of standardized light and amount of light received.
(5) Ultraviolet rays are attenuated by sealing glass or the like of the solid state image apparatus, and almost none are received by the photodiodes.

Furthermore, in the color signal generation unit 642, a column vector made up of a color signal (R, G, B) indicated by the RGB color system, is obtained, as shown by the following Equation (22), by applying a differential matrix [D] held by the differential matrix holding unit 641 to a column vector made up of the signal input into the signal processing unit 640 ($DL_{IC}$, $DL_{RC}$, $DL_{GC}$).

$$(22) \quad \begin{bmatrix} R \\ G \\ B \end{bmatrix} = \begin{bmatrix} D_{11} & D_{12} & D_{13} \\ D_{21} & D_{22} & D_{23} \\ D_{31} & D_{32} & D_{33} \end{bmatrix} \begin{bmatrix} DL_{IC} \\ DL_{RC} \\ DL_{GC} \end{bmatrix}$$

Based on the stated five conditions, the column vector made up of the signal input into the signal processing unit 640 ($DL_{IC}$, $DL_{RC}$, $DL_{GC}$) is expressed, as shown by the following Equation (23), by applying a weight matrix [W] to the column vector made up of the color signal shown by the RGB color system (R, G, B). Note the element of each weight vector [W] is a positive value of at least 0 and no more than 1.

$$(2 3) \begin{bmatrix} DL_{IC} \\ DL_{RC} \\ DL_{GC} \end{bmatrix} = \begin{bmatrix} W_{11} & W_{12} & W_{13} \\ W_{21} & W_{22} & W_{23} \\ W_{31} & W_{32} & W_{33} \end{bmatrix} \begin{bmatrix} R \\ G \\ B \end{bmatrix}$$

$$= \begin{bmatrix} W_{11} & W_{12} & W_{13} \\ 0 & W_{22} & W_{23} \\ 0 & 0 & W_{33} \end{bmatrix} \begin{bmatrix} R \\ G \\ B \end{bmatrix}.$$

Here, it is assumed that an electric signal generated by photo-electric conversion by a photodiode above which an aperture of an infrared ray cutoff dimension is provided is not affected by infrared rays. Similarly, it is assumed that an electric signal generated by photo-electric conversion by a photodiode above which an aperture of a red light cutoff dimension is provided is not affected by red light. Furthermore, it is assumed that an electric signal generated by photo-electric conversion by a photodiode above which an aperture of a green light cutoff dimension is provided is not affected by green light. Further assuming that there is no weight for light that is not affected, $W_{21}$, $W_{31}$, and $W_{32}$ are 0.

Furthermore, if the above Equation (23) is solved with respect to a column vector made up of a color signal shown by the RGB color system (R, G, B), a differential matrix [D] shown by the following Equation (24) is obtained.

$$(2 4) \begin{bmatrix} D_{11} & D_{12} & D_{13} \\ D_{21} & D_{22} & D_{23} \\ D_{31} & D_{32} & D_{33} \end{bmatrix}$$

$$= \begin{bmatrix} \dfrac{1}{W_{11}} & -\dfrac{W_{12}}{W_{11}W_{22}} & \dfrac{W_{12}W_{23} - W_{13}W_{22}}{W_{11}W_{22}W_{33}} \\ 0 & \dfrac{1}{W_{22}} & -\dfrac{W_{23}}{W_{22}W_{33}} \\ 0 & 0 & \dfrac{1}{W_{33}} \end{bmatrix}$$

Here, from the above Equation (24) $D_{11}$, $D_{22}$ and $D_{33}$ are shown to be positive values, and $D_{12}$ and $D_{23}$ are shown to be negative values. Furthermore, $D_{21}$, $D_{31}$ and $D_{32}$ are shown to have a value 0.

Furthermore, when spectral characteristics close to the ideal spectral characteristics shown in FIG. 6, 9 and so on are obtained, the weight of $W_{13}$ and $W_{23}$ is extremely low, and the value of $D_{13}$ is almost 0. Color signals shown by the RGB color system can be generated by taking only two signal differentials between the signals input into the signal processing unit 640 ($DL_{IC}$, $DL_{RC}$, $DL_{GC}$).

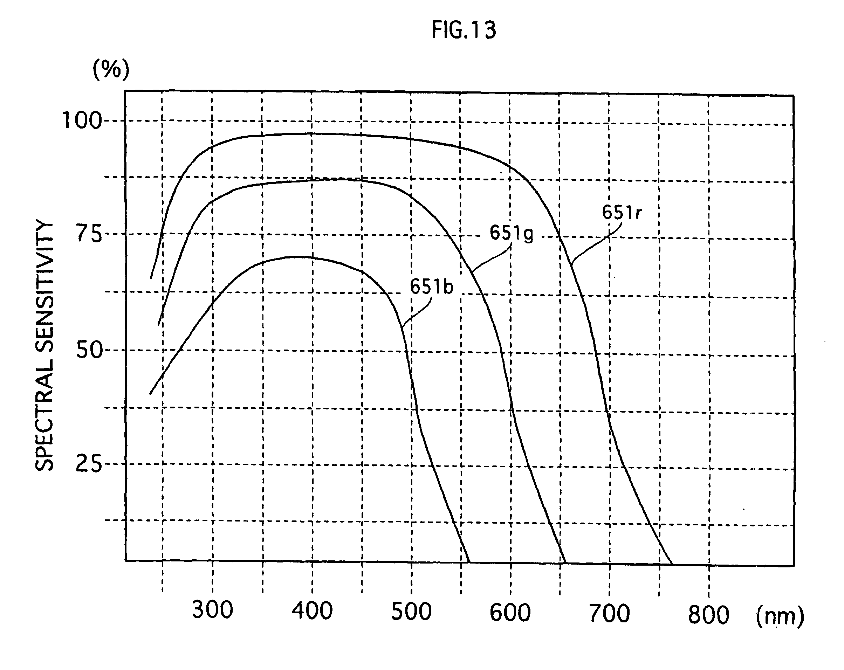

FIG. 13 is a graph showing spectral characteristics that deviate considerably from the ideal spectral characteristics.

As shown in FIG. 13, spectral characteristics of light that is able to pass through an aperture having an infrared ray cutoff dimension is indicated by a curve 651r, spectral characteristics of light that is able to pass through an aperture having a red light cutoff dimension is indicated by a curve 651g, and spectral characteristics of light that is able to pass through an aperture having a green curve cutoff dimension is indicated by a curve 651b.

Spectral sensitivity indicated by curves 651r, 651g and 651b deviates considerably from that indicated by the curves in the second embodiment and the fourth embodiment.

However, as shown by the curves 651r, 651g, and 651b, when the spectral characteristics deviate considerably from those close to the ideal, the weight of $W_{13}$ and $W_{23}$ cannot be ignored, and the value of $D_{13}$ does not necessarily become 0. Furthermore, in this case, color signals shown by the RGB color system (R, G, B) become difficult to generate by taking differentials between only two signals, and the effect of other signals must be included.

As described, the differential matrix is composed of coefficients defined by factors such as the shape and dimensions of the apertures and the sensitivity of the photodiodes. Furthermore, if i is 1, 2, 3, etc., the components of a differential matrix (i, i) are indicated by positive values, and the components (i, i+1), of the differential matrix are indicated by negative values.

<Summary of the Sixth Embodiment>

As described, colour signals are able to be obtained even in a solid-state imaging device from which colour filters are omitted, according to photo-receivers above which apertures of differing cutoff dimensions are provided outputting signals corresponding to the respective cutoff dimension, and the signal processing unit 640 applying differential processing to the signal output by the photodiodes.

Note that the photo-electric conversion unit 610 in the present embodiment may be of a structure that is the photo-electric conversion unit 310 of the third embodiment from which the color filters have been removed, or may be of a structure that is the photo-electric conversion unit 410 of the fourth embodiment from which the colour filters have been removed.

<Other Remarks Regarding the Sixth Embodiment>

Four colours, specifically, red (R), green (G), blue (B) and ultraviolet (UV) may be generated by providing a group of four photodiodes each having a different type of aperture (infrared ray cutoff dimension, red light cutoff dimension, green light cutoff dimension, blue light cutoff dimension that will enable light of ultraviolet rays (380 nm) or below to pass through, but that cuts off light of blue light wave length (450 nm) and greater.

$$(25) \quad \begin{bmatrix} R \\ G \\ B \\ UV \end{bmatrix} = \begin{bmatrix} D_{11} & D_{12} & D_{13} & D_{14} \\ D_{21} & D_{22} & D_{23} & D_{24} \\ D_{31} & D_{32} & D_{33} & D_{34} \\ D_{41} & D_{42} & D_{43} & D_{44} \end{bmatrix} \begin{bmatrix} DL_{IC} \\ DL_{RC} \\ DL_{GC} \\ DL_{BC} \end{bmatrix}$$

Furthermore, four colors, specifically, infrared (IR), red (R), green (G) and blue (B) may be generated by providing a group of four photodiodes each having a different type of aperture (maximum cutoff dimension, infrared ray cutoff dimension, red light cutoff dimension, green light cutoff dimension, respectively) thereabove. Here, as shown by the following Equation (26), the signal processing unit 640 may apply differential processing to the four types of signals output by the photoelectric conversion unit 610, and generate four color signals (IR, R, G, B).

24

$$(26)\begin{bmatrix} IR \\ R \\ G \\ B \end{bmatrix} = \begin{bmatrix} D_{11} & D_{12} & D_{13} & D_{14} \\ D_{21} & D_{22} & D_{23} & D_{24} \\ D_{31} & D_{32} & D_{33} & D_{34} \\ D_{41} & D_{42} & D_{43} & D_{44} \end{bmatrix} \begin{bmatrix} DL_{LC} \\ DL_{IC} \\ DL_{RC} \\ DL_{GC} \end{bmatrix}$$

Furthermore, five colors, specifically, infrared (IR), red (R), green (G), blue (B) and ultraviolet (UV) may be generated by providing a group of five photodiodes each having a different type of aperture (maximum cutoff dimension, infrared ray cutoff dimension, red light cutoff dimension, green light cutoff dimension, and blue light cutoff dimensions, respectively) thereabove. Here, as shown by the following Equation (27), the signal processing unit 640 may apply differential processing to the five types of signals output by the photoelectric conversion unit 610, and generate five color signals (IR, R, G, B, UV).

$$(27)\begin{bmatrix} IR \\ R \\ G \\ B \\ UV \end{bmatrix} = \begin{bmatrix} D_{11} & D_{12} & D_{13} & D_{14} & D_{15} \\ D_{21} & D_{22} & D_{23} & D_{24} & D_{25} \\ D_{31} & D_{32} & D_{33} & D_{34} & D_{35} \\ D_{41} & D_{42} & D_{43} & D_{44} & D_{45} \\ D_{51} & D_{52} & D_{53} & D_{54} & D_{55} \end{bmatrix} \begin{bmatrix} DL_{LC} \\ DL_{IC} \\ DL_{RC} \\ DL_{GC} \\ DL_{BC} \end{bmatrix}$$

In more general terms, $m$ colors may be generated by proving a set of $n$ photodiodes each having a different one of $n$ types of aperture provided thereabove. Here, as shown by the following Equation (28), the signal processing unit 640 may apply differential processing the to $n$ types of signals output by the photoelectric conversion unit 610, and generate color signals of $m$ colors. Note that here the differential matrix is an $m$ by $n$ matrix.

$$(28)\begin{bmatrix} DC_1 \\ DC_2 \\ \vdots \\ DC_{m-1} \\ DC_m \end{bmatrix} = \begin{bmatrix} D_{11} & D_{12} & \cdots & D_{1n-1} & D_{1n} \\ D_{21} & D_{22} & \cdots & D_{2n-1} & D_{2n} \\ \vdots & \vdots & \ddots & \vdots & \vdots \\ D_{m-11} & D_{m-12} & \cdots & D_{m-1n-1} & D_{m-1n} \\ D_{m1} & D_{m2} & \cdots & D_{mn-1} & D_{mn} \end{bmatrix} \begin{bmatrix} DL_1 \\ DL_2 \\ \vdots \\ DL_{n-1} \\ DL_n \end{bmatrix}$$

Note that the color signals (R, G, B) generated by the color signal generation unit 642maybe further converted to complementary color signals (Cy, Mg, Y, G), as shown by the following Equation (29).

$$(29) \begin{bmatrix} Cy \\ Mg \\ Ye \\ G \end{bmatrix} = \begin{bmatrix} 0 & 1 & 1 \\ 1 & 0 & 1 \\ 1 & 1 & 0 \\ 0 & 1 & 0 \end{bmatrix} \begin{bmatrix} R \\ G \\ B \end{bmatrix}$$

The solid-state imaging device 601 may be an element composed of one chip into which the photoelectric conversion unit 610, the signal amplification unit 620, the A/D conversion unit 630 and the signal processing unit 640 are integrated into one chip, or may be an element into which each of the photoelectric conversion unit 610, the signal amplification unit 620, the A/D conversion unit 630 and the signal processing unit 640 are integrated as separate chips.

Furthermore, a plurality of apertures may be provided for one photodiode as with the photoelectric conversion unit 310 of the third embodiment, or a plurality of two types of apertures may be provided as with the photoelectric conversion unit 410 of the fourth embodiment.

The differential matrix holding unit 641 may hold, in advance, a matrix that is a differential matrix multiplied by a correction matrix, and the color signals to which processing to color correction may be generated by the color signal generation unit 642. Furthermore, the generated color signals may be output as is.

<Seventh Embodiment>

The following describes a seventh embodiment of the present invention with reference to the drawings. Note that structural elements having the same structure as those in the sixth embodiment have the same numbering thereas, and are omitted from the following description.

<Outline of the Seventh Embodiment>

The main object of the sixth embodiment is generate signals of RGB format that are necessary when reproducing each color without use of color filters 217r, 217g and 217b, by applying signal processing to electric signals generated by the photoelectric conversion unit from light that passes through three types of apertures which have respectively different cutoff dimensions. In contrast, the seventh embodiment aims to enable more light to pass through the apertures.

The following describes the solid-state imaging device of the seventh embodiment in view of the described aim.

<Solid-state imaging device of the Seventh Embodiment>

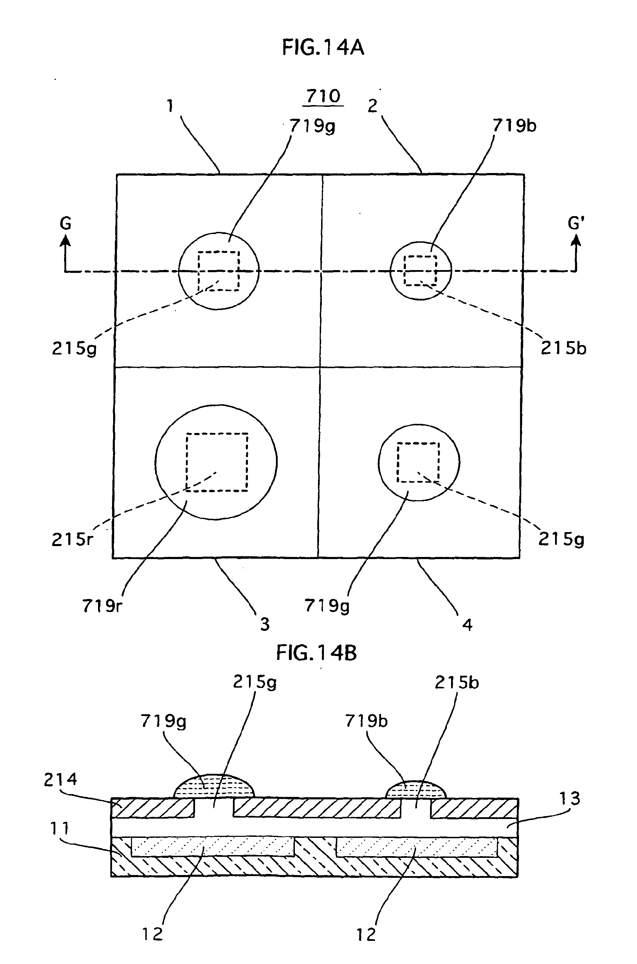

FIG. 14A shows the photoelectric conversion unit of the solid-state imaging device of the seventh embodiment as viewed from above, and FIG. 14B shows a cross section G-G' of the photoelectric conversion unit viewed toward an arrow direction.

Note that for brevity, only one of the pixel units (two by two pixels) among the pixel units that make up the photoelectric conversion unit 710 is shown.

As shown in FIGs. 14A and 14B, in the photoelectric conversion unit 710, microlenses 719r, 719g and 719b are formed on the light shield film 214, so as to cover the apertures 215r, 215g and 215b, respectively.

<Summary of the Seventh Embodiment>

The microlenses formed on the light shield film 214 so as to cover the apertures cause light above the light shield film 214 to be focused into the apertures, thereby enabling the photodiode to receive a greater amount of light, and heightening sensitivity.

<Other Remarks>

If a plurality of apertures are formed with respect to each one photodiode as with the photoelectric conversion units 310 and 410 of the third and fourth embodiments, one microlens may be formed on the light shield film 214 so as to cover the plurality of apertures formed with respect to the one photodiode. Alternatively, a plurality of microlenses may be formed, each covering one or more of the apertures.

Note that the size of the microlenses may vary according the size of the apertures, or all lenses may be of a same size.

<Eighth Embodiment>

The following describes an eighth embodiment of the present invention with reference to the drawings.

<Outline of the Eighth Embodiment>

FIG. 18 shows an example of the structure of a conventional spectral device that uses a prism.

In a spectral device that uses a prism, incident light 1001 can be divided according to wave length by passing through a prism 1002, because the refractive index of the prism 1002 varies according to wavelength.

For example, the wavelength of incident light 1001 is determined according to the positional coordinate 1005 at which light 1003 that passes through the prism 1002 hits a spectral display board 1004 that is placed apart from the prism. The incident light 1001 is red if light hits at a positional coordinate 1005R of the spectral display board 1004, green if light hits at a positional coordinate 1005G of the spectral display board 1004, and blue if light hits at a positional coordinate 1005B of the spectral display board 1004.

However, determining the wavelength of light accurately is difficult with this kind of spectral device because the positional coordinate 1005 of light that hits the spectral display board varies according to a number of factors such as the angle of the incident light 1001 to the prism 1002, and the distance and angle between the prism 1002 and the spectral display board 1004. Therefore, adjustment of this kind of spectral device requires fine operations to make adjustments in a number of places.

Consequently, the less places that need to be adjusted, the more convenient the spectral device.

Furthermore, it is preferable that operations for the spectral device be simple because it is necessary to finely set the frequency and amount of incident light to the photodiodes that make up the solid-state imaging device, to measure the photoelectric conversion characteristics of the photodiodes.

The spectral device of the present embodiment requires adjustment in less places, and simpler operations than a spectral device that uses a conventional prism.

<Spectral Device of the Eight Embodiment>

FIG. 17A shows an example of the structure of a spectral device that spectrally separates one type of light. FIG. 17B shows an example of a spectral device that spectrally separates into a plurality of types of light.

When separating light into a plurality of types of light, a plurality of the spectral device of FIG. 17A are provided to make one spectral device (see FIG. 17B).

When incident light 1001 is incident on a spectral board 1010, light less than a predetermined wavelength passes through an aperture 1013 provided in the spectral board 1010.

The light 1030 that passes through aperture 1013 reaches a spectral display board 1012.

If, for example, the aperture 1013 is a rectangular shape with a long side length of 230 nm, the light 1030 that passes through the aperture is light of a wavelength of blue light (in the vicinity of 450 nm) or less.

The relationship between the shape and dimension of the aperture and the frequency of the light that passes therethrough is the same as in the first embodiment.

Note that the spectral board 1010 may be made, for example, of aluminium (Al) or tungsten (W).

The following describes the spectral device of FIG. 17B that includes a light detection unit instead of the spectral display board 1012 of FIG. 17A. This spectral device is called a spectral measurement device.

The spectral measurement device has apertures 1051, 1052 and 1053 of different dimensions provided in one spectral board, and light 1040 that passes through the apertures 1051, 1052 and 1053 reaches light detectors 1061, 1062 and 1063, respectively, and is photoelectric converted.

Here, it is assumed that each aperture allows light of a different wavelength or less to pass through, and that the spectral characteristics of each aperture have been measured.

Light 1040 of which the spectral characteristics have been measured is incident on the apertures (1051, 1051 and 1053), and after passing through the apertures, is detected by the light detectors (1061, 1062 and 1063). The spectral characteristics of the light 1040 are found based on the correlation between the detected electric signals.

For example, the light that passes through the aperture 1051 is of a wavelength less than blue light, the light that passes through the aperture 1052 is of a wavelength less than green light, and the light that passes through the aperture 1053 is of a wavelength less than red light.

In this case, if the spectral characteristics of the light that passes through the aperture 1051 and the light that passes through the aperture 1052 and is of a wave length less than blue light are the same, the intensity of the wavelength range of green light can be found by subtracting the electric signal detected be the light detector 1061 from the electric signal detected by the light detector 1062. Similarly, the intensity of the wavelength range of red light can be found by subtracting the electric signal detected be the light detector 1062 from the electric signal detected by the light detector 1063.

In reality, apertures that enable spectral characteristics of light of a certain wavelength or less among light that passes through each of the apertures to be uniform is extremely difficult. For this reason, the intensity of necessary light can be found by performing a set matrix processing. Details of this matrix processing are as described in the sixth embodiment.

<Other Remarks Regarding the Eighth Embodiment>

(1) Although the spectral device of the present embodiment is provided with one spectral board having apertures therein, a different spectral board may be provided for each aperture.
Structuring the spectral device to have a plurality of spectral boards has an advantage of enabling fine adjustments. On the other hand, structuring the spectral device to have only one spectral board has an advantage of eliminating the need for positional adjustment between spectral boards to be omitted.
(2) In a spectral device that has a plurality of apertures and separates light into a plurality of lights, spectral separation boards 1011 are effective in preventing mixing of light that passes through apertures near each other.
(3) Although the spectral device of the present embodiment is provided with one aperture to enable light of a certain frequency and below to pass, a plurality of apertures of a same shape may be provided.
Furthermore, a plurality of apertures of different shapes may be provided.
Providing a plurality of apertures enable a greater amount of light to pass through the apertures, and improves the SN ratio of the spectral device or the spectral measurement device. This is as described in the third embodiment.
Furthermore, by combining apertures having different shapes, light having spectral characteristics close to the necessary characteristics can pass through. This is as described in the fourth embodiment.
(4) Although the apertures in the present embodiment are described as having a rectangular shape, they may have another shape such as a round shape or a slit shape.
Although the present invention has been fully described by way of examples with reference to accompanying drawings, it is to be noted that various changes and modifications will be apparent to those skilled in the art. Therefore, unless such changes and modifications depart from the scope of the present invention as defined in the appended claims, they should be construed as being included therein.

**Claims**

1.    A solid-state imaging device, comprising:

     a plurality of photodiodes (12) that each convert received light to an electric signal; and
     a light shield film (114) having a plurality of apertures (115) formed therein, and provided above and isolated from the photodiodes by insulation (13) between the light shield film (114) and the photodiodes (12),

     **characterised in that** the apertures (115) cut off light of a predetermined wavelength or greater and pass light below the predetermined wavelength, the predetermined wavelength being within a range of wavelength to which the photodiodes (12) are sensitive, and
     a shape and a dimension of each aperture are defined according to the predetermined wavelength.

2.    The solid-state imaging device of Claim 1,
     wherein the photodiodes (12) correspond respectively to pixels that are each a minimum unit of an image that is taken, and each of the photodiodes has a different one of the apertures (115) provided thereabove.

3.    The solid-state imaging device of Claim 2,
     wherein the apertures (215 r,g,b) are made up of N (N being a natural number) different types of the apertures, the predetermined wavelength is different for each type of aperture, the photodiodes (12) are N in number, and each of the N photodiodes has an aperture of a different one of the N types provided thereabove.

4.    The solid-state imaging device of Claim 2, that generates color signals of a first color system from N (N being a natural number) types of electric signals generated from light received by the photodiodes (12) which are N in number, based on an M (M being a natural number) by N matrix for converting a column vector whose compositional elements are N types of electric signals, into a column vector whose compositional elements are M types of color signals of the first color system.

5. The solid-state imaging device of Claim 4, that applies color correction to the color signals of the first color system, based on an M by M matrix for correcting the column vector whose compositional elements are the color signals of the first color system.

6. The solid-state imaging device of Claim 4, that converts the color signals of the first color system into color signals of a second colour system, based on an L (L being a natural number) by M matrix for converting the column vector whose compositional elements are color signals of the first color system into a column vector whose compositional elements are color signals of the second color system.

7. The solid-state imaging device of Claim 6, that applies color correction to the color signals of the second color system, the color correction being based on an L by L matrix for correcting a column vector whose compositional elements are color signals of the second color system.

8. The solid-state imaging device of Claim 2,
wherein each photodiode (12) has a plurality of the apertures (315 r,g,b) provided thereabove.

9. The solid-state imaging device of Claim 8,
wherein the plurality of apertures (315 r,g,b) provided above each photodiode (12) consists of (i) one or more apertures that enable light below the predetermined wavelength to pass through, and (ii) one or more apertures that enable light below a different predetermined wavelength to pass through.

10. The solid-state imaging device of Claim 8,
wherein the apertures (315 r,g,b) are arranged so that lengthwise directions of the aperture are parallel with each other, an interval between each aperture being less than or equal to a length direction dimension of the apertures.

11. The solid-state imaging device of Claim 8,
wherein the apertures (315 r,g,b) are arranged so that lengthwise directions of the aperture are parallel with each other, an interval between each aperture being greater than or equal to a length direction dimension of the apertures.

12. The solid-state imaging device of Claim 2, further comprising:

a plurality of microlenses (719 r,g,b), each of which is provided with respect to a different one of the photodiodes (12) and covers the aperture (215 r,g,b) above the respective photodiode.

13. The solid-state imaging device of Claim 2, further comprising:

a plurality of microlenses (719 r,g,b), each of which covers a different one or more of the apertures (215 r,g,b).

14. The solid-state imaging device of Claim 2,
wherein the insulation (13) is of a thickness that is equal to or greater than a minimum dimension of the apertures (115), and equal to or less than a maximum wavelength of light to be converted by the photodiodes (12).

15. The solid-state imaging device of Claim 2,
wherein each aperture (115) is one of rectangular and circular in shape, and
the dimension defined according to the predetermined wavelength is a long side of the aperture if the aperture is rectangular, and a diameter of the aperture if the aperture is circular.

16. The solid-state imaging device of Claim 2,
wherein the predetermined wavelength is a wavelength of one of near infrared light, red light, green light, and blue light in a medium formed over the aperture (115).

17. The solid-state imaging device of Claim 2,
wherein the apertures (515) have a long, narrow rectangular shape, and are arranged such that a lengthwise direction of each aperture is oriented in a same direction.

**18.** The solid-state imaging device of Claim 2,
wherein the apertures (515) have a long, narrow rectangular shape, a plurality of apertures is provided with respect to each photodiode (12), and arranged such that a lengthwise direction of the apertures for each photodiode is oriented in one of (i) a first direction and (ii) a second direction that is orthogonal to the first direction.

**19.** A camera (100) that includes a solid-state imaging device (101) according to claim 2.

**20.** The camera of Claim 19, wherein
the apertures are made up of N (N being a natural number) different types of the apertures (215 r,g,b), the predetermined wavelength is different for each type of aperture, the photodiodes (12) are N in number, and each of the N photodiodes has an aperture of a different one of the N types provided thereabove, and
the solid-state imaging device (101) further comprises:

a signal processing circuit that processes N types of electric signals generated from light received respectively by the N photodiodes (12) provided above the apertures (215 r,g,b) whose form and dimensions are defined based on the respective predetermined wavelength, and
the signal processing device generates, from the N types of electric signals, color signals of a first color system, based on a differential matrix for converting a vector whose compositional elements are the N types of electric signals into a vector whose compositional elements are M (M being a natural number) types of color signals of a first color system, by taking a difference between an electric signal in the N types of electric signals and a neighboring electric signal in the N types of electric signals.

**21.** The camera of Claim 19, further including a signal processing apparatus that processes N (N being a natural number) types of electric signals output by the solid-state imaging device (101),
wherein, in the solid-state imaging device, the apertures are made up of N different types of the apertures (215 r, g,b), the predetermined wavelength is different for each type of aperture, the photodiodes (12) are N in number, and each of the N photodiodes has apertures of a different one of the N types provided thereabove,
the solid-state imaging device outputs to the signal processing device, N types of electric signals generated from light received respectively by the N photodiodes (12) provided above the apertures (215 r,g,b) whose shape and dimensions are defined based on the respective predetermined wavelength, and
the signal processing device generates, from the N types of electric signals, color signals of a first color system, based on a differential matrix for converting a vector whose compositional elements are the N types of electric signals into a vector whose compositional elements are M (M being a natural number) types of color signals of a first color system, by taking a difference between an electric signal in the N types of electric signals and a neighboring electric signal in the N types of electric signals.

**22.** The camera of Claim 19, further comprising:

at least one more of the solid-state imaging device (101), the solid-state imaging devices totalling N in number, and in each solid-state imaging device, the apertures being made up of N (N being a natural number) different types of the apertures (215 r,g,b), the predetermined wavelength being different for each type of aperture, the photodiodes (12) being N in number, and each of the N photodiodes having apertures of a different one of the N types provided thereabove; and
a signal processing device that processes N types of electric signals output by the solid-state imaging device,

wherein the solid-state imaging device outputs to the signal processing device, N types of electric signals generated from light received respectively by the N photodiodes (12) provided above the apertures (215 r,g,b) whose shape and dimensions are defined based on the respective predetermined wavelength, and
the signal processing device generates, from the N types of electric signals, color signals of a first color system, based on a differential matrix for converting a vector whose compositional elements are the N types of electric signals into a vector whose compositional elements are M (M being a natural number) types of color signals of a first color system, by taking a difference between an electric signal in the N types of electric signals and a neighboring electric signal in the N types of electric signals.

**Patentansprüche**

**1.** Halbleiter-Bilderzeugungsvorrichtung, die umfasst:

eine Vielzahl von Fotodioden (12), die jeweils empfangenes Licht in ein elektrisches Signal umwandeln; und einen Lichtabschirmfilm (114) mit einer Vielzahl darin ausgebildeter Öffnungen (115), der oberhalb und gegenüber den Fotodioden durch Isolierung (13) zwischen dem Lichtabschirmfilm (114) und den Fotodioden (12) isoliert vorhanden ist,

**dadurch gekennzeichnet, dass** die Öffnungen (115) Licht einer vorgegebenen Wellenlänge oder darüber sperren und Licht unterhalb der vorgegebenen Wellenlänge durchlassen, wobei die vorgegebene Wellenlänge innerhalb eines Wellenlängenbereiches liegt, für den die Fotodioden (12) empfindlich sind, und eine Form und eine Abmessung jeder Öffnung gemäß der vorgegebenen Wellenlänge definiert sind.

2. Halbleiter-Bilderzeugungsvorrichtung nach Anspruch 1, wobei die Fotodioden (12) jeweils Pixeln entsprechen, die jeweils eine minimale Einheit eines aufgenommenen Bildes sind, und über jeder der Fotodioden eine verschiedene der Öffnungen (115) vorhanden ist.

3. Halbleiter-Bilderzeugungsvorrichtung nach Anspruch 2, wobei die Öffnungen (215 r, g, b) aus N (wobei N eine natürliche Zahl ist) verschiedenen Typen der Öffnung bestehen, die vorgegebene Wellenlänge für jeden Typ Öffnung verschieden ist, die Anzahl der Fotodioden (12) N beträgt und über jeder der N Fotodioden eine Öffnung eines verschiedenen der N Typen vorhanden ist.

4. Halbleiter-Bilderzeugungsvorrichtung nach Anspruch 2, die Farbsignale eines ersten Farbsystems aus N (wobei N eine natürliche Zahl ist) Typen elektrischer Signale, die aus durch die Fotodioden (12), deren Anzahl N beträgt, empfangenem Licht erzeugt werden, auf Basis einer Matrix von M x N (wobei M eine natürliche Zahl ist) zum Umwandeln eines Spaltenvektors, dessen Bestandteile N Typen elektrischer Signale sind, in einen Spaltenvektor, dessen Bestandteile M Typen von Farbsignalen des ersten Farbsystems sind, erzeugt.

5. Halbleiter-Bilderzeugungsvorrichtung nach Anspruch 4, die Farbkorrektur an den Farbsignalen des ersten Farbsystems auf Basis einer Matrix von M x M zum Korrigieren des Spaltenvektors, dessen Bestandteile die Farbsignale des ersten Farbsystems sind, vornimmt.

6. Halbleiter-Bilderzeugungsvorrichtung nach Anspruch 4, die die Farbsignale des ersten Farbsystems in Farbsignale eines zweiten Farbsystems auf Basis einer Matrix von L x M (wobei L eine natürliche Zahl ist) zum Umwandeln des Spaltenvektors, dessen Bestandteile Farbsignale des ersten Farbsystems sind, in einen Spaltenvektor, dessen Bestandteile Farbsignale des zweiten Farbsystems sind, umwandelt.

7. Halbleiter-Bilderzeugungsvorrichtung nach Anspruch 6, die Farbkorrektur an den Farbsignalen des zweiten Farbsystems vornimmt, wobei die Farbkorrektur auf einer Matrix von L x L zum Korrigieren eines Spaltenvektors, dessen Bestandteile Farbsignale des zweiten Farbsystems sind, basiert.

8. Halbleiter-Bilderzeugungsvorrichtung nach Anspruch 2, wobei über jeder Fotodiode (12) eine Vielzahl der Öffnungen (315 r, g, b) vorhanden ist.

9. Halbleiter-Bilderzeugungsvorrichtung nach Anspruch 8, wobei die Vielzahl von Öffnungen (315 r, g, b), die über jeder Fotodiode (12) vorhanden sind, aus (I) einer oder mehreren Öffnungen, die Licht unterhalb der vorgegebenen Wellenlänge hindurch treten lassen, und (II) einer oder mehreren Öffnungen besteht, die Licht unterhalb einer anderen vorgegebenen Wellenlänge hindurch treten lassen.

10. Halbleiter-Bilderzeugungsvorrichtung nach Anspruch 8, wobei die Öffnungen (315 r, g, b) so angeordnet sind, dass Längsrichtungen der Öffnung parallel zueinander sind und ein Zwischenraum zwischen jeder Öffnung kleiner ist als oder genauso groß wie eine Längsrichtungsabmessung der Öffnungen.

11. Halbleiter-Bilderzeugungsvorrichtung nach Anspruch 8, wobei die Öffnungen (315 r, g, b) so angeordnet sind, dass Längsrichtungen der Öffnung parallel zueinander sind und ein Zwischenraum zwischen jeder Öffnung größer ist als oder genauso groß wie eine Längsrichtungsabmessung der Öffnungen.

12. Halbleiter-Bilderzeugungsvorrichtung nach Anspruch 2, die des Weiteren umfasst:

eine Vielzahl von Mikrolinsen (719 r, g, b), von denen jede in Bezug auf eine andere der Fotodioden (12) vorhanden ist und die Öffnung (215 r, g, b) oberhalb der jeweiligen Fotodiode abdeckt.

13. Halbleiter-Bilderzeugungsvorrichtung nach Anspruch 2, die des Weiteren umfasst:

   eine Vielzahl von Mikrolinsen (719 r, g, b), von denen jede eine oder mehrere verschiedene der Öffnungen (215 r, g, b) abdeckt.

14. Halbleiter-Bilderzeugungsvorrichtung nach Anspruch 2,
   wobei die Isolierung (13) eine Dicke hat, die genauso groß ist wie oder größer als eine minimale Abmessung der Öffnungen (115) und genauso groß wie oder kleiner als eine maximale Wellenlänge von Licht, das durch die Fotodioden (12) umgewandelt werden soll

15. Halbleiter-Bilderzeugungsvorrichtung nach Anspruch 2,
   wobei jede Öffnung (115) Rechteck- oder Kreisform hat, und
   die Abmessung, die gemäß der vorgegebenen Wellenlänge definiert ist, eine lange Seite der Öffnung ist, wenn die Öffnung rechteckig ist, und ein Durchlass der Öffnung, wenn die Öffnung kreisförmig ist.

16. Halbleiter-Bilderzeugungsvorrichtung nach Anspruch 2,
   wobei die vorgegebene Wellenlänge eine Wellenlänge von Nah-Infrarotlicht, rotem Licht, grünem Licht oder blauem Licht in einem Medium ist, das über der Öffnung (115) ausgebildet ist.

17. Halbleiter-Bilderzeugungsvorrichtung nach Anspruch 2,
   wobei die Öffnungen (515) eine lange schmale Rechteckform haben und so angeordnet sind, dass eine Längsrichtung jeder Öffnung in einer gleichen Richtung ausgerichtet ist.

18. Halbleiter-Bilderzeugungsvorrichtung nach Anspruch 2,
   wobei die Öffnungen (515) eine lange schmale Rechteckform haben, eine Vielzahl von Öffnungen in Bezug auf jede Fotodiode (12) vorhanden und so angeordnet ist, dass eine Längsrichtung der Öffnungen für jede Diode in (I) einer ersten Richtung oder (II) einer zweiten Richtung, die rechtwinklig zu der ersten Richtung ist, ausgerichtet ist.

19. Kamera (100), die eine Halbleiter-Bilderzeugungsvorrichtung (101) nach Anspruch 2 enthält.

20. Kamera nach Anspruch 19, wobei
   die Öffnungen aus N (wobei N eine natürliche Zahl ist) verschiedenen Typen der Öffnungen (215 r, g, b) bestehen, die vorgegebene Wellenlänge für jeden Typ Öffnung verschieden ist, die Anzahl der Fotodioden (12) N beträgt und über jeder der N Fotodioden Öffnungen eines verschiedenen der N Typen vorhanden sind, und
   die Halbleiter-Bilderzeugungsvorrichtung (101) des Weiteren umfasst:

   eine Signalverarbeitungsschaltung, die N Typen elektrischer Signale verarbeitet, die aus jeweils durch die N Fotodioden (12) empfangenem Licht erzeugt werden, die über den Öffnungen (215 r, g, b) vorhanden sind, deren Form und Abmessungen auf Basis der jeweiligen vorgegebenen Wellenlänge definiert sind, und
   die Signalverarbeitungsvorrichtung aus den N Typen elektrischer Signale Farbsignale eines ersten Farbsystems auf Basis einer Differenzmatrix zum Umwandeln eines Vektors, dessen Bestandteile die N Typen elektrischer Signale sind, in einen Vektor, dessen Bestandteile M (wobei M eine natürliche Zahl ist) Typen von Farbsignalen eines ersten Farbsystems sind, durch Bilden einer Differenz zwischen einem elektrischen Signal von den N Typen elektrischer Signale und einem benachbarten elektrischen Signal von den N Typen elektrischer Signale erzeugt.

21. Kamera nach Anspruch 19, die des Weiteren eine Signalverarbeitungsvorrichtung enthält, die N (wobei N eine natürliche Zahl ist) Typen elektrischer Signale verarbeitet, die durch die Halbleiter-Bilderzeugungsvorrichtung (101) ausgegeben werden,
   wobei in der Halbleiter-Bilderzeugungsvorrichtung die Öffnungen aus N verschiedenen Typen der Öffnungen (215 r, g, b) bestehen, die vorgegebene Wellenlänge für jeden Typ Öffnung verschieden ist, die Anzahl der Fotodioden (12) N beträgt und über jeder der N Fotodioden Öffnungen eines verschiedenen der N Typen vorhanden sind,
   die Halbleiter-Bilderzeugungsvorrichtung an die Signalverarbeitungsvorrichtung N Typen elektrischer Signale ausgibt, die aus jeweils durch die N Fotodioden (12) empfangenem Licht erzeugt werden, die oberhalb den Öffnungen (215 r, g, b) vorhanden sind, deren Form und Abmessungen auf Basis der jeweiligen vorgegebenen Wellenlänge definiert sind, und

die Signalverarbeitungsvorrichtung aus den N Typen elektrischer Signale Farbsignale eines ersten Farbsystems auf Basis einer Differenzmatrix zum Umwandeln eines Vektors, dessen Bestandteile die N Typen elektrischer Signale sind, in einen Vektor, dessen Bestandteile M (wobei M eine natürliche Zahl ist) Typen von Farbsignalen eines ersten Farbsystems sind, durch Bilden einer Differenz zwischen einem elektrischen Signal von den N Typen elektrischer Signale und einem benachbarten elektrischen Signal von den N Typen elektrischer Signale erzeugt.

**22.** Kamera nach Anspruch 19, die des Weiteren umfasst:

wenigstens eine weitere der Halbleiter-Bilderzeugungsvorrichtungen (101), wobei die Gesamtzahl der Halbleiter-Bilderzeugungsvorrichtungen N beträgt und in jeder Halbleiter-Bilderzeugungsvorrichtung die Öffnungen aus N (wobei N eine natürliche Zahl ist) verschiedenen Typen der Öffnungen (215 r, g, b) bestehen, die vorgegebene Wellenlänge für jeden Typ Öffnung verschieden ist, die Anzahl der Fotodioden (12) N beträgt und über jeder der N Fotodioden Öffnungen eines verschiedenen der N Typen vorhanden sind; und

eine Signalverarbeitungsvorrichtung die N Typen elektrischer Signale verarbeitet, die durch die Halbleiter-Bilderzeugungsvorrichtung ausgegeben werden,

wobei die Halbleiter-Bilderzeugungsvorrichtung an die Signalverarbeitungsvorrichtung N Typen elektrischer Signale ausgibt, die aus jeweils durch die N Fotodioden (12) empfangenem Licht erzeugt werden, die oberhalb der Öffnungen (215 r, g, b) vorhanden sind, deren Form und Abmessungen auf Basis der jeweiligen vorgegebenen Wellenlänge definiert sind, und

die Signalverarbeitungsvorrichtung aus den N Typen elektrischer Signale Farbsignale eines ersten Farbsystems auf Basis einer Differenzmatrix zum Umwandeln eines Vektors, dessen Bestandteile die N Typen elektrischer Signale sind, in einen Vektor, dessen Bestandteile M (wobei M eine natürliche Zahl ist) Typen von Farbsignalen eines ersten Farbsystems sind, durch Bilden einer Differenz zwischen einem elektrischen Signal von den N Typen elektrischer Signale und einem benachbarten elektrischen Signal von den N Typen elektrischer Signale erzeugt.

## Revendications

1.  Dispositif de formation d'image à l'état solide, comprenant :

    une pluralité de photodiodes (12) qui convertissent chacune la lumière reçue en un signal électrique ; et
    un film de protection à la lumière (114) ayant une pluralité d'ouvertures (115) formée à l'intérieur et prévu au dessus et isolé des photodiodes par une isolation (13) entre le film de protection à la lumière (114) et les photodiodes (12),

    **caractérisé en ce que** les ouvertures (115) coupent la lumière d'une longueur d'onde prédéterminée ou supérieure et font passer la lumière en dessous de la longueur d'onde prédéterminée, la longueur d'onde prédéterminée se trouvant dans une plage de longueur d'onde à laquelle les photodiodes (12) sont sensibles, et
    une forme et une dimension de chaque ouverture sont définies selon la longueur d'onde prédéterminée.

2.  Dispositif de formation d'image à l'état solide selon la revendication 1,
    dans lequel les photodiodes (12) correspondent respectivement aux pixels qui sont chacun une unité minimale d'une image qui est prise, et chacune des photodiodes a une, différente, des ouvertures (115) prévue au dessus d'elle.

3.  Dispositif de formation d'image à l'état solide selon la revendication 2,
    dans lequel les ouvertures (215, r, g, b) sont composées de N (N étant un entier naturel) types différents des ouvertures, la longueur d'onde prédéterminée est différente pour chaque type d'ouverture, les photodiodes (12) sont N en nombre et chacune des N photodiodes a une ouverture d'un, différent, des N types prévue au dessus d'elle.

4.  Dispositif de formation d'image à l'état solide selon la revendication 2, qui génère des signaux de couleur d'un premier système de couleur de N (N étant un entier naturel) types de signaux électriques générés depuis la lumière reçue par les photodiodes (12) qui sont N en nombre, sur la base d'une matrice M (M étant un entier naturel) par N afin de convertir un vecteur de colonne dont les éléments composants sont N types de signaux électriques, en un vecteur de colonne dont les éléments composants sont M types de signaux de couleur du premier système de couleur.

**5.** Dispositif de formation d'image à l'état solide selon la revendication 4, qui applique une correction de couleur aux signaux de couleur du premier système de couleur, sur la base d'une matrice M par M pour corriger le vecteur de couleur dont les éléments composants sont les signaux de couleur du premier système de couleur.

**6.** Dispositif de formation d'image à l'état solide selon la revendication 4, qui convertit les signaux de couleur du premier système de couleur en signaux de couleur d'un second système de couleur, sur la base d'une matrice L (L étant un entier naturel) par M afin de convertir le vecteur de colonne dont les éléments composants sont des signaux de couleur du premier système de couleur en un vecteur de colonne dont les éléments composants sont des signaux de couleur du second système de couleur.

**7.** Dispositif de formation d'image à l'état solide selon la revendication 6 qui applique une correction de couleur aux signaux de couleur du second système de couleur, la correction de couleur étant basée sur une matrice L par L afin de corriger un vecteur de colonne dont les éléments composants sont des signaux de couleur du second système de couleur.

**8.** Dispositif de formation d'image à l'état solide selon la revendication 2,
dans lequel chaque photodiode (12) a une pluralité des ouvertures (315, r, g, b) prévue au dessus d'elle.

**9.** Dispositif de formation d'image à l'état solide selon la revendication 8,
dans lequel la pluralité d'ouvertures (315, r, g, b) prévue au dessus de chaque photodiode (12) consiste en (i) une ou plusieurs ouvertures qui permettent à la lumière en dessous de la longueur d'onde prédéterminée de passer et (ii) une ou plusieurs ouvertures qui permettent à la lumière en dessous d'une longueur d'onde prédéterminée différente de passer.

**10.** Dispositif de formation d'image à l'état solide selon la revendication 8,
dans lequel les ouvertures (315, r, g, b) sont agencées de telle sorte que les directions de longueur de l'ouverture sont parallèles les unes aux autres, un intervalle entre chaque ouverture étant inférieur ou égal à une dimension dans la direction de la longueur des ouvertures.

**11.** Dispositif de formation d'image à l'état solide selon la revendication 8,
dans lequel les ouvertures (315, r, g, b) sont agencées de telle sorte que les directions de longueur de l'ouverture sont parallèles les unes aux autres, un intervalle entre chaque ouverture étant supérieur ou égal à une dimension dans la direction de la longueur des ouvertures.

**12.** Dispositif de formation d'image à l'état solide selon la revendication 2, comprenant en outre :

une pluralité de micro lentilles (719, r, g, b) dont chacune est prévue par rapport à une, différente, des photodiodes (12) et recouvre l'ouverture (215, r, g, b) au dessus de la photodiode respective.

**13.** Dispositif de formation d'image à l'état solide selon la revendication 2, comprenant en outre :

une pluralité de micro lentilles (719, r, g, b) dont chacune recouvre une, différente, ou plusieurs des ouvertures (215, r, g, b).

**14.** Dispositif de formation d'image à l'état solide selon la revendication 2,
dans lequel l'isolation (13) est d'une épaisseur qui est égale ou supérieure à une dimension minimale des ouvertures (115) et égale ou inférieure à une longueur d'onde maximale de la lumière devant être convertie par les photodiodes (12).

**15.** Dispositif de formation d'image à l'état solide selon la revendication 2,
dans lequel chaque ouverture (115) a une d'une forme rectangulaire et circulaire, et
la dimension définie selon la longueur d'onde prédéterminée est un côté long de l'ouverture si l'ouverture est rectangulaire et un diamètre de l'ouverture si l'ouverture est circulaire.

**16.** Dispositif de formation d'image à l'état solide selon la revendication 2,
dans lequel la longueur d'onde prédéterminée est une longueur d'onde d'un de la lumière infrarouge proche, la lumière rouge, la lumière verte et la lumière bleue dans un milieu formé sur l'ouverture (115).

**17.** Dispositif de formation d'image à l'état solide selon la revendication 2,
dans lequel les ouvertures (515) ont une forme rectangulaire longue étroite et sont agencées de telle sorte qu'une direction de la longueur de chaque ouverture est orientée dans la même direction.

**18.** Dispositif de formation d'image à l'état solide selon la revendication 2,
dans lequel les ouvertures (515) ont une forme rectangulaire longue étroite, une pluralité d'ouvertures est prévue par rapport à chaque photodiode (12) et agencées de telle sorte qu'une direction de la longueur des ouvertures pour chaque photodiode est orientée dans une de (i) une première direction et (ii) une deuxième direction qui est orthogonale à la première direction.

**19.** Appareil photo (100) qui comprend un dispositif de formation d'image à l'état solide (101) selon la revendication 2.

**20.** Appareil photo selon la revendication 19, dans lequel
les ouvertures sont composés de N (N étant un entier naturel) types différents des ouvertures (215, r, g, b), la longueur d'onde prédéterminée est différente pour chaque type d'ouverture, les photodiodes (12) sont N en nombre et chacune des N photodiodes a une ouverture d'un, différent, des N types prévue au dessus d'elle, et
le dispositif de formation d'image à l'état solide (101) comprend en outre :

un circuit de traitement de signal qui traite N types de signaux électriques générés depuis la lumière reçue respectivement par les N photodiodes (12) prévues au dessus des ouvertures (215, r, g, b) dont la forme et les dimensions sont définies sur la base de la longueur d'onde prédéterminée respective, et
le dispositif de traitement de signal génère, à partir des N types de signaux électriques, des signaux de couleur d'un premier système de couleur, sur la base d'une matrice différentielle afin de convertir un vecteur dont les éléments composants sont les N types de signaux électriques en un vecteur dont les éléments composants sont M (M étant un entier naturel) types de signaux de couleur d'un premier système de couleur, en prenant une différence entre un signal électrique dans les N types de signaux électriques et un signal électrique voisin dans les N types de signaux électriques.

**21.** Appareil photo selon la revendication 19, comprenant en outre un appareil de traitement de signal qui traite N (N étant un entier naturel) types de signaux électriques émis en sortie par le dispositif de formation d'image à l'état solide (101),
dans lequel, dans le dispositif de formation d'image à l'état solide, les ouvertures sont composées de N types différents des ouvertures (215, r, g, b), la longueur d'onde prédéterminée est différente pour chaque type d'ouverture, les photodiodes (12) sont N en nombre et chacune des N photodiodes a des ouvertures d'un, différent, des N types prévues au dessus d'elle,
le dispositif de formation d'image à l'état solide émet en sortie vers le dispositif de traitement de signal, N types de signaux électriques générés depuis la lumière reçue respectivement par les N photodiodes (12) prévues au dessus des ouvertures (215, r, g, b) dont la forme et les dimensions sont définies sur la base de la longueur d'onde prédéterminée respective, et
le dispositif de traitement de signal génère, à partir des N types de signaux électriques, des signaux de couleur d'un premier système de couleur, sur la base d'une matrice différentielle afin de convertir un vecteur dont les éléments composants sont les N types de signaux électriques en un vecteur dont les éléments composants sont M (M étant un entier naturel) types de signaux de couleur d'un premier système de couleur, en prenant une différence entre un signal électrique dans les N types de signaux électriques et un signal électrique voisin dans les N types de signaux électriques.

**22.** Appareil photo selon la revendication 19, comprenant en outre :

au moins un ou plusieurs du dispositif de formation d'image à l'état solide (101), les dispositifs de formation d'image à l'état solide totalisant N en nombre et dans chaque dispositif de formation d'image à l'état solide, les ouvertures étant composées de N (N étant un entier naturel) types différents des ouvertures (215, r, g, b), la longueur d'onde prédéterminée étant différente pour chaque type d'ouverture, les photodiodes (12) étant N en nombre et chacune des N photodiodes ayant des ouvertures d'un, différent, des N types prévues au dessus d'elle ; et
un dispositif de traitement de signal qui traite N types de signaux électriques émis en sortie par le dispositif de formation d'image à l'état solide,

dans lequel le dispositif de formation d'image à l'état solide émet en sortie vers le dispositif de traitement de signal,

35

N types de signaux électriques générés depuis la lumière reçue respectivement par les N photodiodes (12) prévues au dessus des ouvertures (215, r, g, b) dont la forme et les dimensions sont définies sur la base de la longueur d'onde prédéterminée respective, et

le dispositif de traitement de signal génère, à partir des N types de signaux électriques, des signaux de couleur d'un premier système de couleur, sur la base d'une matrice différentielle afin de convertir un vecteur dont les éléments composants sont les N types de signaux électriques en un vecteur dont les éléments composants sont M (M étant un entier naturel) types de signaux de couleur d'un premier système de couleur, en prenant une différence entre un signal électrique dans les N types de signaux électriques et un signal électrique voisin dans les N types de signaux électriques.

FIG.1

100

101

## FIG.2A

## FIG.2B

FIG.3

130

131                    132

| MATERIAL | REFRACTIVE INDEX |
|---|---|
| AIR | 1 |
| PYROGLASS | 1.46 |
| POLY-SILICON | $3.42 - i\,(\,\alpha\,\lambda\,/\,2\,\pi\,)$ |
| SILICON | $3.42 - i\,(\,\alpha\,\lambda\,/\,2\,\pi\,)$ |
| $Si\,O_2$ | 1.46 |
| $Si_3\,N_4$ | ~2 |
| $In_2\,O_3$ | 1.97 |

FIG.4

EP 1 475 963 B1

## FIG.5A

## FIG.5B

FIG.6

## FIG.7A

## FIG.7B

## FIG.8A

410

1    217g    2    217b

D'

416b
415b

416g
415g

416r

415r

217r      3      217g      4

415g

416g

D

## FIG.8B

416g    416g    416b    416b
415g      415b   415b    217b

217g

414

16

13

11

12          12

FIG.9

## FIG.10A

510

1   17g   2   17b

E → ... ← E'

515   515

515   515

17r   17g

3   4

## FIG.10B

515   515   515   515   515   515

17g   17b

514   16

11   13

12   12

# FIG.11

601

640

SIGNAL PROCESSING UNIT

LIGHT

610

PHOTOELECTRIC
CONVERSION UNIT

641

DIFFERENTIAL
MATRIX HOLDING
UNIT

643

CORRECTION
MATRIX HOLDING
UNIT

620

SIGNAL AMPLIFICATION
UNIT

630

A/D
CONVERSION
UNIT

642

COLOR SIGNAL
GENERATION
UNIT

644

COLOR SIGNAL
CORRECTION UNIT

EP 1 475 963 B1

## FIG.12A

<u>610</u>

1    2

F                                              F'

215g                                          215b

215r                                          215g

3                                              4

## FIG.12B

215g                        215b

214

16

13

11

12                          12

FIG.13

EP 1 475 963 B1

## FIG.14A

710

## FIG.14B

# FIG.15A
# PRIOR ART

# FIG.15B

## FIG.16

PRIOR ART

EP 1 475 963 B1

## FIG.17A

## FIG.17B

FIG.18

PRIOR ART